# EUROPEAN PATENT APPLICATION

(11) **EP 4 654 264 A1**
(43) Date of publication of application: **26.11.2025**
(21) Application number: 24744589.3
(22) Date of filing: 12.01.2024
(51) Int. Cl.: H01L 27/146

(54) **SEMICONDUCTOR DEVICE**

(30) Priority: 20.01.2023 JP 2023007415
(71) Applicant: Sony Semiconductor Solutions Corporation, Atsugi-shi, Kanagawa 243-0014 (JP)
(72) Inventor: NISHIDA, Yoshiki, Atsugi-shi, Kanagawa 243-0014 (JP); SUTO, Minami, Atsugi-shi, Kanagawa 243-0014 (JP); KANDA, Masao, Atsugi-shi, Kanagawa 243-0014 (JP)
(74) Representative: MFG Patentanwälte Meyer-Wildhagen Meggle-Freund Gerhard PartG mbB
(86) International application number: PCT/JP2024/000623
(87) International publication number: WO 2024/154666

(57) **Abstract**

A decrease in charge transfer efficiency in a semiconductor apparatus is prevented. The semiconductor apparatus includes a charge transfer section and a transfer path adjustment section. The charge transfer section is configured by a MOS transistor including a first semiconductor region disposed in a semiconductor substrate, a second semiconductor region disposed in the vicinity of a surface of the semiconductor substrate, and a transfer gate embedded in the vicinity of the surface of the semiconductor substrate and having a bottom portion being a gate electrode formed in the vicinity of the first semiconductor region, and transfers a charge from one of the first semiconductor region and the second semiconductor region to the other. The transfer path adjustment section is disposed adjacent to the transfer gate, has a bottom portion constituted by an insulator formed in the vicinity of the bottom portion of the transfer gate, and adjusts a transfer path of the charge in the charge transfer section.

## Description

### Field

The present disclosure relates to a semiconductor apparatus.

### Background

A photodetection apparatus, which is a semiconductor apparatus that images a subject and generates an image signal, includes a pixel array section in which pixels that generate an image signal on the basis of incident light are arranged in a two-dimensional matrix. In this pixel, a photoelectric conversion section such as a photodiode that performs photoelectric conversion of incident light, a charge holding section that holds a charge generated by photoelectric conversion, and a charge transfer section that transfers the charge of the photoelectric conversion section to the charge holding section are arranged. Furthermore, in the pixel, a pixel circuit that generates an image signal on the basis of the charge held in the charge holding section is arranged.

The charge generated by the photoelectric conversion section during the exposure period is transferred to the charge holding section and held therein. After the end of the exposure period, the pixel circuit generates an image signal on the basis of the charge held in the charge holding section, and outputs the image signal to the peripheral circuit of the pixel array section.

For such a photodetection apparatus, a back-illuminated photodetection apparatus is used in which a charge holding section and a pixel circuit are formed on a front surface side of a semiconductor substrate, a photoelectric conversion section is formed inside the semiconductor substrate, and light from a subject enters the photoelectric conversion section from a back surface side of the semiconductor substrate. In this photodetection apparatus, a charge transfer section that transfers the charge of the photoelectric conversion section inside the semiconductor substrate to the front surface side of the semiconductor substrate is disposed. The charge transfer section is configured by a MOS transistor embedded in a semiconductor substrate and having a vertical gate configured in a columnar shape to transfer a charge in a thickness direction of the semiconductor substrate.

For such a back-illuminated photodetection apparatus, there has been proposed a photodetection apparatus (solid-state imaging apparatus) configured in a shape in which a semiconductor region of a photodiode constituting a photoelectric conversion section extends below a MOS transistor constituting a charge transfer section (see, for example, Patent Literature 1).

### Citation List

### Patent Literature

Patent Literature 1: JP 2005-223084 A

### Summary

### Technical Problem

However, in the above-described conventional technique, the charge transfer path (channel) formed along the vertical gate of the charge transfer section has a complicated shape to reach the charge holding section from the bottom surface via the side surface of the vertical gate. In some transfer paths, when the charge transfer section is made conductive, a potential barrier is generated, and the charge cannot reach the charge holding section. For this reason, there is a problem that charge transfer efficiency decreases. This decrease in charge transfer efficiency occurs significantly in a case where the amount of charge to be transferred is small.

Therefore, the present disclosure proposes a semiconductor apparatus that prevents a decrease in charge transfer efficiency.

### Solution to Problem

A semiconductor apparatus according to the present disclosure includes a charge transfer section and a transfer path adjustment section. The charge transfer section is configured by a MOS transistor including a first semiconductor region disposed in a semiconductor substrate, a second semiconductor region disposed in the vicinity of a surface of the semiconductor substrate, and a transfer gate embedded in the vicinity of the surface of the semiconductor substrate, having a bottom portion formed in the vicinity of the first semiconductor region and being a gate electrode, and is configured to transfer a charge from one of the first semiconductor region and the second semiconductor region to the other. The transfer path adjustment section is disposed adjacent to the transfer gate, has a bottom portion constituted by an insulator formed in the vicinity of the bottom portion of the transfer gate, and adjusts a transfer path of the charge in the charge transfer section.

### Brief Description of Drawings

FIG. 1 is a diagram illustrating an example of a schematic configuration of a photodetection apparatus according to a first embodiment of the present disclosure.
FIG. 2 is a diagram illustrating another example of a schematic configuration of the photodetection apparatus according to the first embodiment of the present disclosure.
FIG. 3 is a diagram illustrating a configuration example of a pixel according to an embodiment of the present disclosure.
FIG. 4 is a diagram illustrating a configuration example of a pixel according to the first embodiment of the present disclosure.
FIG. 5 is a diagram illustrating a configuration example of a pixel according to the first embodiment of the present disclosure.
FIG. 6 is a diagram illustrating an example of adjustment of a charge transfer path according to the first embodiment of the present disclosure.
FIG. 7A is a diagram illustrating an example of a method for manufacturing the photodetection apparatus according to the first embodiment of the present disclosure.
FIG. 7B is a diagram illustrating an example of the method for manufacturing the photodetection apparatus according to the first embodiment of the present disclosure.
FIG. 7C is a diagram illustrating an example of the method for manufacturing the photodetection apparatus according to the first embodiment of the present disclosure.
FIG. 7D is a diagram illustrating an example of the method for manufacturing the photodetection apparatus according to the first embodiment of the present disclosure.
FIG. 7E is a diagram illustrating an example of the method for manufacturing the photodetection apparatus according to the first embodiment of the present disclosure.
FIG. 7F is a diagram illustrating an example of the method for manufacturing the photodetection apparatus according to the first embodiment of the present disclosure.
FIG. 7G is a diagram illustrating an example of the method for manufacturing the photodetection apparatus according to the first embodiment of the present disclosure.
FIG. 8A is a diagram illustrating a configuration example of a pixel according to a second embodiment of the present disclosure.
FIG. 8B is a diagram illustrating a configuration example of a pixel according to the second embodiment of the present disclosure.
FIG. 8C is a diagram illustrating a configuration example of a pixel according to the second embodiment of the present disclosure.
FIG. 9A is a diagram illustrating another configuration example of the pixel according to the second embodiment of the present disclosure.
FIG. 9B is a diagram illustrating another configuration example of the pixel according to the second embodiment of the present disclosure.
FIG. 10A is a diagram illustrating a configuration example of a pixel according to the second embodiment of the present disclosure.
FIG. 10B is a diagram illustrating a configuration example of a pixel according to the second embodiment of the present disclosure.
FIG. 10C is a diagram illustrating a configuration example of a pixel according to the second embodiment of the present disclosure.
FIG. 11A is a diagram illustrating a configuration example of a pixel according to the second embodiment of the present disclosure.
FIG. 11B is a diagram illustrating a configuration example of a pixel according to the second embodiment of the present disclosure.
FIG. 11C is a diagram illustrating a configuration example of a pixel according to the second embodiment of the present disclosure.
FIG. 12A is a diagram illustrating another configuration example of the pixel according to the second embodiment of the present disclosure.
FIG. 12B is a diagram illustrating another configuration example of the pixel according to the second embodiment of the present disclosure.
FIG. 13A is a diagram illustrating another configuration example of the pixel according to the second embodiment of the present disclosure.
FIG. 13B is a diagram illustrating another configuration example of the pixel according to the second embodiment of the present disclosure.
FIG. 14A is a diagram illustrating a configuration example of a pixel according to a third embodiment of the present disclosure.
FIG. 14B is a diagram illustrating a configuration example of a transfer gate according to the third embodiment of the present disclosure.
FIG. 15A is a diagram illustrating another configuration example of the pixel according to the third embodiment of the present disclosure.
FIG. 15B is a diagram illustrating another configuration example of the pixel according to the third embodiment of the present disclosure.
FIG. 15C is a diagram illustrating another configuration example of the pixel according to the third embodiment of the present disclosure.
FIG. 16A is a diagram illustrating a configuration example of a pixel according to a fourth embodiment of the present disclosure.
FIG. 16B is a diagram illustrating a configuration example of a transfer gate according to the fourth embodiment of the present disclosure.
FIG. 17A is a diagram illustrating an example of a method for manufacturing the photodetection apparatus according to the fourth embodiment of the present disclosure.
FIG. 17B is a diagram illustrating an example of the method for manufacturing the photodetection apparatus according to the fourth embodiment of the present disclosure.
FIG. 17C is a diagram illustrating an example of the method for manufacturing the photodetection apparatus according to the fourth embodiment of the present disclosure.
FIG. 17D is a diagram illustrating an example of the method for manufacturing the photodetection apparatus according to the fourth embodiment of the present disclosure.
FIG. 17E is a diagram illustrating an example of the method for manufacturing the photodetection apparatus according to the fourth embodiment of the present disclosure.
FIG. 17F is a diagram illustrating an example of the method for manufacturing the photodetection apparatus according to the fourth embodiment of the present disclosure.
FIG. 17G is a diagram illustrating an example of the method for manufacturing the photodetection apparatus according to the fourth embodiment of the present disclosure.
FIG. 18A is a diagram illustrating a configuration example of a transfer gate according to a fifth embodiment of the present disclosure.
FIG. 18B is a diagram illustrating a configuration example of a transfer gate according to the fifth embodiment of the present disclosure.
FIG. 18C is a diagram illustrating a configuration example of a transfer gate according to the fifth embodiment of the present disclosure.
FIG. 19A is a diagram illustrating another configuration example of the transfer gate according to the fifth embodiment of the present disclosure.
FIG. 19B is a diagram illustrating another configuration example of the transfer gate according to the fifth embodiment of the present disclosure.
FIG. 20A is a diagram illustrating another configuration example of the transfer gate according to the fifth embodiment of the present disclosure.
FIG. 20B is a diagram illustrating another configuration example of the transfer gate according to the fifth embodiment of the present disclosure.
FIG. 20C is a diagram illustrating another configuration example of the transfer gate according to the fifth embodiment of the present disclosure.
FIG. 20D is a diagram illustrating another configuration example of the transfer gate according to the fifth embodiment of the present disclosure.
FIG. 20E is a diagram illustrating another configuration example of the transfer gate according to the fifth embodiment of the present disclosure.
FIG. 21 is a diagram illustrating another configuration example of the transfer gate according to the fifth embodiment of the present disclosure.
FIG. 22A is a diagram illustrating another configuration example of the transfer gate according to the fifth embodiment of the present disclosure.
FIG. 22B is a diagram illustrating another configuration example of the transfer gate according to the fifth embodiment of the present disclosure.
FIG. 22C is a diagram illustrating another configuration example of the transfer gate according to the fifth embodiment of the present disclosure.
FIG. 23 is a block diagram illustrating a configuration example of a photodetection apparatus mounted on an electronic device.
FIG. 24 is a block diagram depicting an example of schematic configuration of a vehicle control system as an example of a mobile body control system to which the technology according to an embodiment of the present disclosure can be applied.
FIG. 25 is a diagram depicting an example of an installation position of an imaging section.
FIG. 26 is a view depicting an example of a schematic configuration of an endoscopic surgery system to which the technology according to an embodiment of the present disclosure (the present technology) can be applied.
FIG. 27 is a block diagram depicting an example of functional configurations of a camera head and a CCU depicted in FIG. 26.

### Description of Embodiments

Hereinafter, embodiments of the present disclosure will be described in detail with reference to the drawings. The description will be given in the following order. Note that, in each of the following embodiments, the same parts are denoted by the same reference signs, and redundant description will be omitted.
1. First Embodiment
2. Second Embodiment
3. Third Embodiment
4. Fourth Embodiment
5. Fifth Embodiment
6. Configuration of Electronic Device
7. Application Example to Mobile Body
8. Application Example to Endoscopic Surgery System

### (1. First Embodiment)

### [Configuration of Photodetection Apparatus]

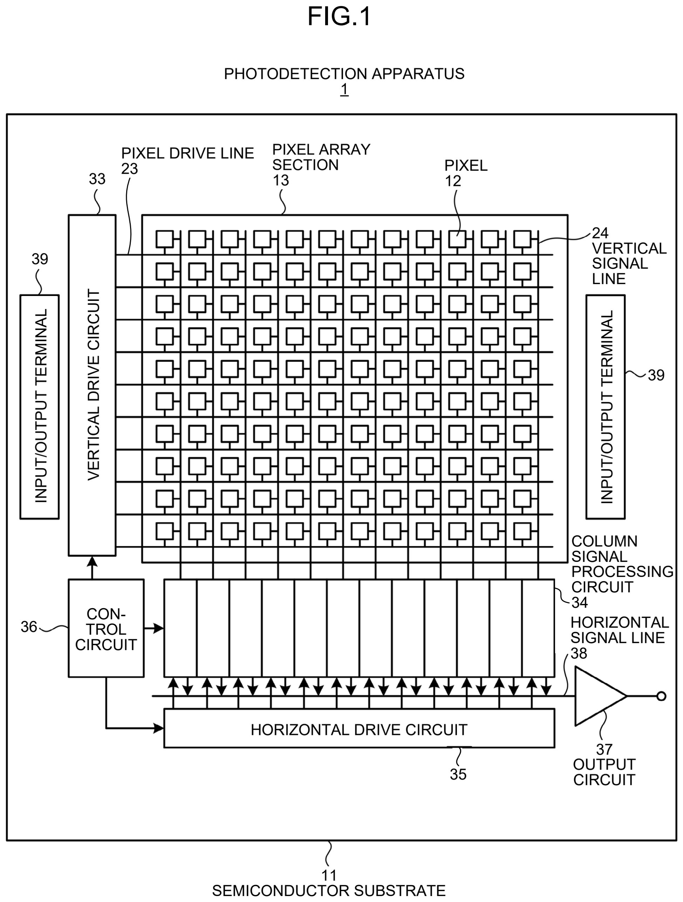

FIG. 1 is a diagram illustrating an example of a schematic configuration of a photodetection apparatus according to a first embodiment of the present disclosure. As illustrated in FIG. 1, a photodetection apparatus 1 of the present example includes a pixel array section (so-called imaging region) 13 in which pixels 12 including a plurality of photoelectric conversion sections are regularly and two-dimensionally arranged on a semiconductor substrate 11, for example, a silicon substrate, and a peripheral circuit section. The pixel 12 includes, for example, a photodiode serving as a photoelectric conversion section and a plurality of pixel transistors (so-called MOS transistors). The plurality of pixel transistors can include, for example, three transistors of a transfer transistor, a reset transistor, and an amplification transistor. In addition, a selection transistor may be added to form four transistors. The pixels 12 may have a shared pixel structure. This pixel sharing structure includes a plurality of photodiodes, a plurality of transfer transistors, one shared floating diffusion region, and one shared pixel transistor.

The peripheral circuit section includes a vertical drive circuit 33, a column signal processing circuit 34, a horizontal drive circuit 35, an output circuit 37, a control circuit 36, and the like.

The control circuit 36 receives an input clock and data instructing an operation mode and the like, and outputs data such as internal information of the imaging element. That is, the control circuit 36 generates a clock signal or a control signal serving as a reference of operations of the vertical drive circuit 33, the column signal processing circuit 34, the horizontal drive circuit 35, and the like on the basis of the vertical synchronization signal, the horizontal synchronization signal, and the master clock. Then, these signals are input to the vertical drive circuit 33, the column signal processing circuit 34, the horizontal drive circuit 35, and the like.

The vertical drive circuit 33 includes, for example, a shift register, selects a pixel drive line 23, supplies a pulse for driving pixels to the selected pixel drive line, and drives the pixels in units of rows. That is, the vertical drive circuit 33 sequentially selects and scans each pixel 12 in the pixel array section 13 in the vertical direction in units of rows, and supplies a pixel signal based on a signal charge generated according to the amount of received light in, for example, a photodiode serving as a photoelectric conversion section of each pixel 12 to the column signal processing circuit 34 through the vertical signal line 24.

The column signal processing circuit 34 is arranged, for example, for each column of the pixels 12, and performs signal processing such as noise removal on the signals output from the pixels 12 of one row for each pixel column. That is, the column signal processing circuit 34 performs signal processing such as correlated double sampling (CDS) for removing fixed pattern noise unique to the pixel 12, signal amplification, and AD conversion. A horizontal selection switch (not illustrated) is connected and provided between an output stage of the column signal processing circuit 34 and a horizontal signal line 38.

The horizontal drive circuit 35 includes, for example, a shift register, sequentially selects each of the column signal processing circuits 34 by sequentially outputting horizontal scanning pulses, and causes each of the column signal processing circuits 34 to output a pixel signal to the horizontal signal line 38.

The output circuit 37 performs signal processing on the signals sequentially supplied from each of the column signal processing circuits 34 through the horizontal signal line 38, and outputs the processed signals. For example, only buffering may be performed, or black level adjustment, column variation correction, various digital signal processing, and the like may be performed. An input/output terminal 39 exchanges signals with the outside.

Note that the drawing illustrates an example of a case where the photodetection apparatus 1 is formed on the semiconductor substrate 11. The photodetection apparatus 1 can also include a plurality of semiconductor substrates. By laminating a plurality of substrates constituting the photodetection apparatus 1, the size (area) of the photodetection apparatus 1 can be reduced. An example of this case will be described next. Note that the photodetection apparatus 1 is an example of a "semiconductor apparatus" of the present disclosure.

### [Another Configuration of Photodetection Apparatus]

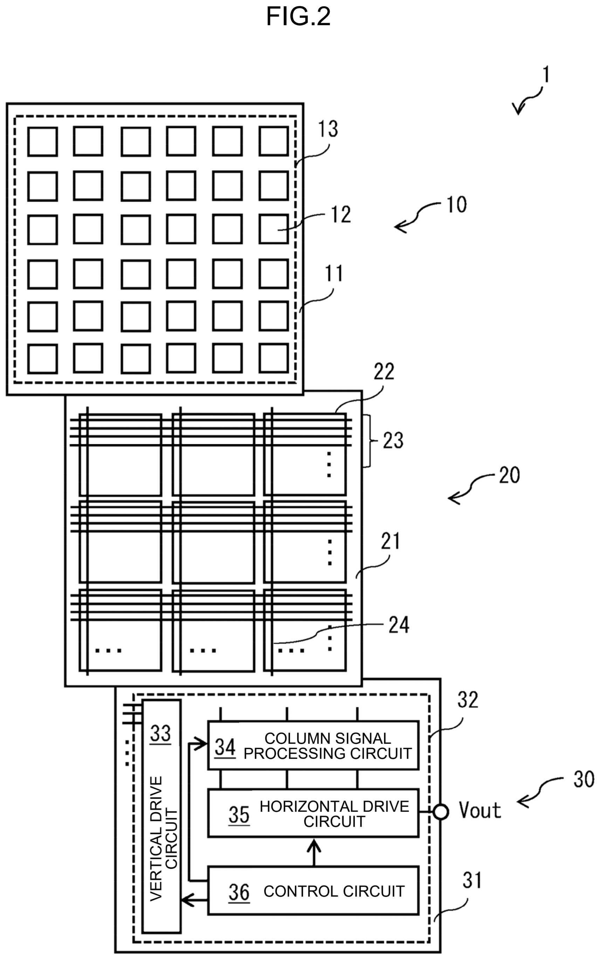

FIG. 2 is a diagram illustrating another example of the schematic configuration of the photodetection apparatus according to the first embodiment of the present disclosure. The photodetection apparatus 1 in the drawing includes three substrates (first substrate 10, second substrate 20, and third substrate 30). The photodetection apparatus 1 has a three-dimensional structure formed by bonding three substrates (first substrate 10, second substrate 20, and third substrate 30). The first substrate 10, the second substrate 20, and the third substrate 30 are laminated in this order.

The first substrate 10 includes a plurality of pixels 12 that performs photoelectric conversion on the semiconductor substrate 11. The plurality of pixels 12 is provided in a matrix in the pixel array section 13 of the first substrate 10. The second substrate 20 includes, on a semiconductor substrate 21, one pixel circuit 22 for each of four pixels 12 that outputs a pixel signal based on the charge output from the pixel 12. The second substrate 20 includes a plurality of pixel drive lines 23 extending in the row direction and a plurality of vertical signal lines 24 extending in the column direction. The third substrate 30 includes a logic circuit 32 that processes a pixel signal on a semiconductor substrate 31. The logic circuit 32 includes, for example, a vertical drive circuit 33, a column signal processing circuit 34, a horizontal drive circuit 35, and a control circuit 36. The logic circuit 32 (specifically, the horizontal drive circuit 35) outputs the output voltage Vout for each pixel 12 to the outside. In the logic circuit 32, for example, a low-resistance region constituted by silicide formed using a salicide (self aligned silicide) process such as CoSi₂ or NiSi may be formed on the surface of the impurity diffusion region in contact with the source electrode and the drain electrode.

For example, the vertical drive circuit 33 sequentially selects the plurality of pixels 12 row by row. The column signal processing circuit 34 performs, for example, correlated double sampling (CDS) processing on the pixel signal output from each pixel 12 of the row selected by the vertical drive circuit 33. The column signal processing circuit 34 extracts a signal level of a pixel signal by performing CDS processing, for example, and holds pixel data corresponding to the amount of received light of each pixel 12. For example, the horizontal drive circuit 35 sequentially outputs the pixel data held in the column signal processing circuit 34 to the outside. The control circuit 36 controls driving of each block (vertical drive circuit 33, column signal processing circuit 34, and horizontal drive circuit 35) in the logic circuit 32, for example. Note that the semiconductor substrate 11 is an example of a " semiconductor substrate" of the present disclosure. The pixel circuit 22 is an example of a "signal generation section" of the present disclosure.

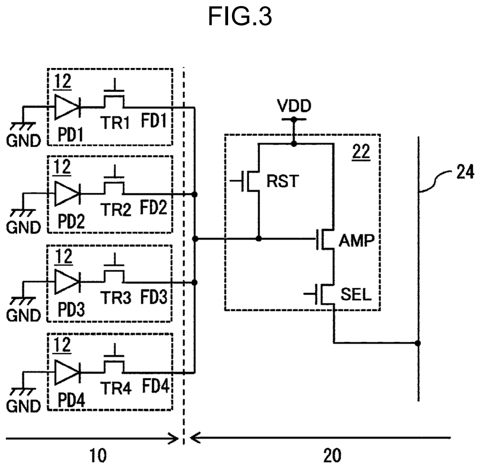

FIG. 3 is a diagram illustrating a configuration example of a pixel according to an embodiment of the present disclosure. FIG. 3 is a circuit diagram illustrating a configuration example of the pixel 12, and illustrates an example of the pixel 12 and the pixel circuit 22. Hereinafter, as illustrated in FIG. 3, a case where four pixels 12 share one pixel circuit 22 will be described. Here, "sharing" means that the outputs of the four pixels 12 are input to the common pixel circuit 22.

Each pixel 12 has a common component. In FIG. 3, in order to distinguish the components of each pixel 12 from each other, an identification number (1, 2, 3, and 4) is added to the end of the reference sign of the component of each pixel 12. Hereinafter, in a case where it is necessary to distinguish the components of each pixel 12 from each other, an identification number is assigned to the end of the reference sign of the component of each pixel 12, but in a case where it is not necessary to distinguish the components of each pixel 12 from each other, the identification number at the end of the reference sign of the component of each pixel 12 is omitted.

Each pixel 12 includes, for example, a photodiode PD, a charge transfer section TR electrically connected to the photodiode PD, and a floating diffusion FD constituting a charge holding section that temporarily holds a charge output from the photodiode PD via the charge transfer section TR. The photodiode PD corresponds to a specific example of a "photoelectric conversion element" of the present disclosure. The photodiode PD performs photoelectric conversion to generate a charge corresponding to the amount of received light. The cathode of the photodiode PD is electrically connected to the source of the charge transfer section TR, and the anode of the photodiode PD is electrically connected to a reference potential line (for example, ground). The drain of the charge transfer section TR is electrically connected to the floating diffusion FD, and the gate of the charge transfer section TR is electrically connected to the pixel drive line 23. The charge transfer section TR is, for example, a metal oxide semiconductor (MOS) transistor.

The floating diffusion FD of each pixel 12 sharing one pixel circuit 22 is electrically connected to each other and is electrically connected to an input terminal of the common pixel circuit 22. The pixel circuit 22 includes, for example, a reset transistor RST, a selection transistor SEL, and an amplification transistor AMP. Note that the selection transistor SEL may be omitted as necessary. The source of the reset transistor RST (the input terminal of the pixel circuit 22) is electrically connected to the floating diffusion FD, and the drain of the reset transistor RST is electrically connected to the power supply line VDD and the drain of the amplification transistor AMP. The gate of the reset transistor RST is electrically connected to the pixel drive line 23 (see FIG. 2). The source of the amplification transistor AMP is electrically connected to the drain of the selection transistor SEL, and the gate of the amplification transistor AMP is electrically connected to the source of the reset transistor RST. The source of the selection transistor SEL (the output terminal of the pixel circuit 22) is electrically connected to the vertical signal line 24, and the gate of the selection transistor SEL is electrically connected to the pixel drive line 23 (see FIG. 2).

When turned on, the charge transfer section TR transfers the charge of the photodiode PD to the floating diffusion region FD. The reset transistor RST resets the potential of the floating diffusion region FD to a predetermined potential. When the reset transistor RST is turned on, the potential of the floating diffusion region FD is reset to the potential of the power supply line VDD. The selection transistor SEL controls an output timing of the pixel signal from the pixel circuit 22. The amplification transistor AMP generates a signal of a voltage corresponding to the level of the charge held in the floating diffusion region FD as a pixel signal. The amplification transistor AMP constitutes a source follower type amplifier, and outputs a pixel signal having a voltage corresponding to the level of the charge generated in the photodiode PD. When the selection transistor SEL is turned on, the amplification transistor AMP outputs a voltage corresponding to the potential of the floating diffusion region FD to the column signal processing circuit 34 via the vertical signal line 24. The reset transistor RST, the amplification transistor AMP, and the selection transistor SEL are, for example, MOS transistors.

### [Configuration of Pixel]

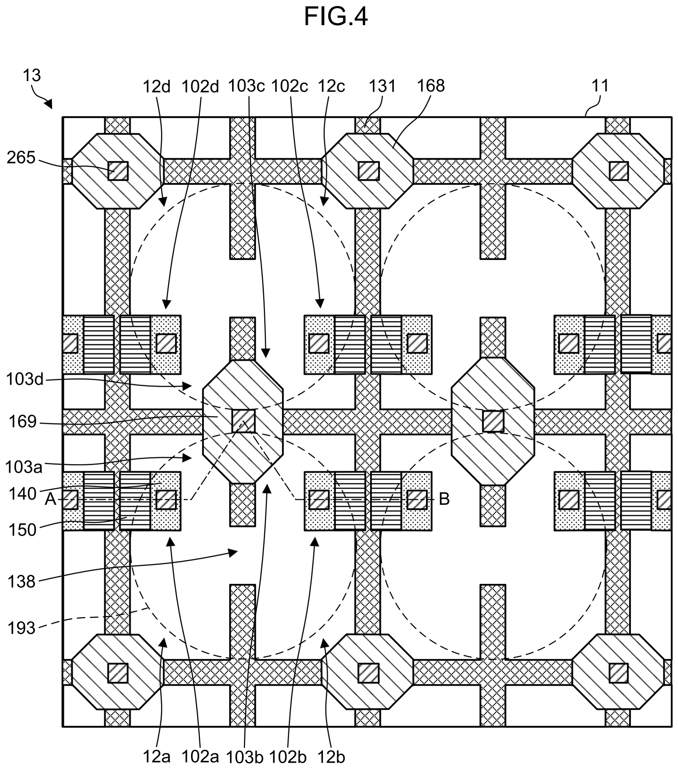

FIG. 4 is a diagram illustrating a configuration example of a pixel according to the first embodiment of the present disclosure. FIG. 4 is a diagram illustrating a configuration example of the pixel 12 included in the pixel array section 13. Furthermore, FIG. 4 is a diagram illustrating a configuration of the pixel 12 on the front surface side of the semiconductor substrate 11. In the semiconductor substrate of FIG. 4, the four pixels 12 (pixel 12a, pixel 12b, pixel 12c, and pixel 12d) described in FIG. 3 are described. A photoelectric conversion section 101 (not illustrated), a charge transfer section 102 (corresponding to TR in FIG. 3), and a charge holding section 103 (corresponding to FD in FIG. 2) are arranged for each of these pixels 12. Note that the charge transfer section 102 and the charge holding section 103 are identified by adding "a" to "d" to reference signs. The separation section 131 is arranged at the boundary of the pixel 12.

The pixels 12a to 12d are formed in rectangular shapes in plan view. As illustrated in FIG. 4, the pixels 12a and 12b have a square shape in plan view, and an on-chip lens 193 to be described later is commonly arranged. Dotted circles in FIG. 4 represent outer shapes of the on-chip lenses 193.

The pixels 12a and 12b have the function of phase difference pixels. The phase difference pixel is a pixel that detects an image plane phase difference obtained by pupil-dividing the subject image. In this case, pixel signals are individually generated in the pixels 12a and 12b. The image plane phase difference is detected on the basis of the pixel signal. A slit-shaped opening 138 is formed in the separation section 131 between the pixels 12a and 12b. The opening 138 constitutes an overflow path between the photoelectric conversion sections 101a and 101b included in the pixels 12a and 12b, respectively. This overflow path can reduce an error in image plane phase difference detection.

Note that, when the pixels 12a and 12b are used as normal pixels, for example, the charges of the photoelectric conversion sections 101a and 101b are simultaneously transferred to charge holding sections 103a and 103b, and a pixel signal is generated.

The charge holding sections 103a and 103b are arranged at upper corner portions of the pixels 12a and 12b in FIG. 4, respectively. As described later, the charge holding section 103a and the like are configured by the semiconductor region 122 constituting the floating diffusion region. Furthermore, the charge transfer sections 102a and 102b are arranged between the centers of the pixels 12a and 12b and the charge holding sections 103a and 103b, respectively.

The pixels 12c and 12d are configured to have shapes symmetrical to those of the pixels 12a and 12b. The charge holding sections 103a to 103d are arranged at corner portions where the pixels 12a to 12d are close to each other, and are commonly connected to a shared electrode 169. In the pixel 12a or the like, the shared electrode 168 is arranged at a corner portion facing the charge holding section 103a or the like. The shared electrode 168 is an electrode that supplies a reference potential to the semiconductor substrate 11 in the pixel 12a or the like. In this manner, the charge holding sections 103a to 103d can be arranged at the end portions of the pixels 12a to 12d, respectively.

A through wiring 265 is disposed in the shared electrode 168, the shared electrode 169, and a transfer gate 140 to be described later. The through wiring 265 is connected to a wiring of the semiconductor substrate 21 described later.

As described later, the photoelectric conversion section 101 is formed inside the semiconductor substrate 11. The charge transfer section 102 includes a MOS transistor that transfers a charge in the thickness direction of the semiconductor substrate 11. The MOS transistor includes a gate electrode arranged to be embedded in the surface of the semiconductor substrate 11 and having a bottom portion formed in the vicinity of the photoelectric conversion section 101. This gate electrode is referred to as a transfer gate. FIG. 4 illustrates the transfer gate 140. The transfer gate 140 is a gate electrode configured in a columnar shape and corresponds to the above-described vertical gate.

A transfer path adjustment section 150 is arranged adjacent to the transfer gate 140. The transfer path adjustment section 150 includes an insulator and adjusts a transfer path of the charge in the charge transfer section 102. Details of the configuration of the transfer path adjustment section 150 will be described later.

### [Configuration of Cross Section of Pixel]

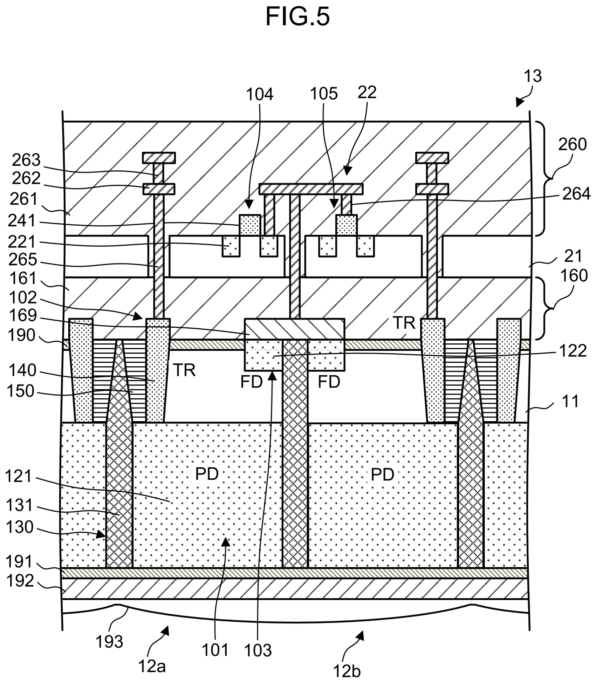

FIG. 5 is a diagram illustrating a configuration example of a pixel according to the first embodiment of the present disclosure. FIG. 5 is a cross-sectional view illustrating a configuration example of the pixel 12 in the pixel array section 13. The pixel 12 in FIG. 5 includes a semiconductor substrate 11, a wiring region 160, a semiconductor substrate 21, a wiring region 260, a color filter 192, and an on-chip lens 193. Note that the pixels 12a and 12b are illustrated in FIG. 5. The configuration of the pixel 12 will be described by taking the portion of the pixel 12a as an example. Note that FIG. 5 is a diagram schematically illustrating a shape of a cross section taken along line A-B in FIG. 4.

The semiconductor substrate 11 is a semiconductor substrate on which the photoelectric conversion section 101 and the like are disposed. The charge transfer section 102 and the charge holding section 103 are further disposed on the semiconductor substrate 11 in FIG. 5. The semiconductor substrate 11 can be constituted by, for example, silicon (Si). The photoelectric conversion section 101 and the like are arranged in a well region formed in the semiconductor substrate 11. For convenience, the semiconductor substrate 11 in FIG. 5 is assumed to constitute a p-type well region. By arranging n-type and p-type semiconductor regions in the p-type well region, an element (diffusion layer thereof) can be formed.

A rectangle described in the semiconductor substrate 11 of FIG. 5 represents an n-type semiconductor region. The photoelectric conversion section 101a includes an n-type semiconductor region 121. Specifically, a photodiode constituted by a pn junction formed at an interface between the n-type semiconductor region 121 and a surrounding p-type well region corresponds to the photoelectric conversion section 101.

The charge holding section 103 includes an n-type semiconductor region 122 configured to have a relatively high impurity concentration. The n-type semiconductor region 122 constitutes the above-described floating diffusion region. In addition, the shared electrode 169 is arranged adjacent to the charge holding section 103. The shared electrode 169 can be constituted by polycrystalline silicon containing impurities. As described above, the shared electrode 169 is formed in a shape straddling the separation section 131 and is arranged adjacent to the semiconductor region 122 of the charge holding sections 103a to 103d. As a result, the charge holding sections 103a to 103d are commonly connected to the shared electrode 169.

The charge transfer section 102 includes n-type semiconductor regions 121 and 122 and the transfer gate 140. The n-type semiconductor regions 121 and 122 correspond to the source region and the drain region of the charge transfer section 102. The transfer gate 140 is disposed on the front surface side of the semiconductor substrate 11 and is configured in a columnar shape partially embedded in the semiconductor substrate 11. In addition, the transfer gate 140 is configured to have a depth at which the bottom portion reaches the vicinity of the n-type semiconductor region 121. When an on-voltage is applied to the transfer gate 140, a channel is formed in the semiconductor region on the surface of the transfer gate 140, and the n-type semiconductor regions 121 and 122 are brought into a conductive state. That is, conduction is established between the photoelectric conversion section 101 and the charge holding section 103, and the charge of the photoelectric conversion section 101 is transferred to the charge holding section 103. In this manner, the charge transfer section 102 transfers the charge in the thickness direction of the semiconductor substrate 11. Note that the transfer gate 140 can be constituted by polycrystalline silicon containing impurities. Note that the semiconductor region 121 is an example of a "first semiconductor region" in the present disclosure. The semiconductor region 122 is an example of a "second semiconductor region" of the present disclosure.

The insulating films 190 and 191 are disposed on the front surface side and the back surface side of the semiconductor substrate 11, respectively. The insulating films 190 and 191 can be constituted by, for example, silicon oxide (SiO₂) or silicon nitride (SiN). Note that, although not illustrated, an insulating film 190 is also disposed between the transfer gate 140 and the semiconductor substrate 11. The insulating film 190 between the transfer gate 140 and the semiconductor substrate 11 corresponds to a gate insulating film.

The separation section 131 is arranged at a boundary of the pixels 12 to separate the pixels 12. The separation section 131 can be configured by embedding an insulator such as SiO₂ in the groove portion 130 penetrating from the front surface side to the back surface side of the semiconductor substrate 11.

The wiring region 160 is a region that is disposed on the front surface side of the semiconductor substrate 11 and in which wiring for transmitting signals and the like of elements is disposed. The wiring region 160 of FIG. 5 includes an insulating layer 161. The insulating layer 161 insulates the shared electrode 169, wiring, and the like disposed on the front surface side of the semiconductor substrate 11. The insulating layer 161 can be constituted by, for example, SiO₂.

The semiconductor substrate 21 is a semiconductor substrate on which a pixel circuit 22 is disposed. The semiconductor substrate 21 is laminated on the semiconductor substrate 11. The back surface of the semiconductor substrate 21 is bonded to the surface of the wiring region 160 of the semiconductor substrate 11, and the semiconductor substrates 11 and 21 are laminated. Similarly to the semiconductor substrate 11, the semiconductor substrate 21 can be constituted by Si. As described above, a reset transistor 104 (corresponding to RST in FIG. 3), an amplification transistor 105 (corresponding to AMP in FIG. 3), and a selection transistor (corresponding to SEL in FIG. 3) (not illustrated) constituting the pixel circuit 22 are disposed on the semiconductor substrate 21. FIG. 5 illustrates the reset transistor 104 and the amplification transistor 105. In the semiconductor substrate 21 of FIG. 5, a gate electrode 241 and a semiconductor region 221 constituting the source and the drain of the reset transistor 104 are described. In addition, an insulating film (not illustrated) is disposed on the front surface of the semiconductor substrate 21.

The wiring region 260 is a wiring region disposed on the front surface side of the semiconductor substrate 21. The wiring region 260 includes a wiring 262, a via plug 263, a contact plug 264, and an insulating layer 261.

Similarly to the insulating layer 161, the insulating layer 261 insulates wiring and the like. The insulating layer 261 can be constituted by, for example, SiO₂.

The wiring 262 transmits a signal or the like to the element of the pixel 12. The wiring 262 can be constituted by metal such as copper (Cu) or W, for example. The via plug 263 electrically connects the wirings 262 arranged in different layers. The via plug 263 can be constituted by, for example, columnar Cu. The contact plug 264 electrically connects the wiring 262 to the semiconductor region and the gate electrode of the semiconductor substrate 21. The contact plug 253 can be constituted by, for example, a columnar W or the like.

Note that the through wiring 265 is connected to a wiring 262 in FIG. 5. As described above, the through wiring 265 is a wiring that connects the transfer gate 140 or the shared electrode 169 of the semiconductor substrate 11 and the wiring 262. The through wiring 265 is formed in a shape penetrating the semiconductor substrate 21. Specifically, the through wiring 265 is disposed in an opening penetrating the semiconductor substrate 21, and is insulated from the semiconductor substrate 21 by the insulating layer 261.

The color filter 192 is an optical filter that transmits light of a predetermined wavelength among the incident light. As the color filter 192, for example, a color filter that transmits red light, green light, and blue light can be used.

The on-chip lens 193 is a lens that condenses incident light. The on-chip lens 193 is formed in, for example, a hemispherical shape, and condenses incident light on the photoelectric conversion section 101. An example in which the on-chip lens 193 in FIG. 5 is commonly arranged in the pixels 12a and 12b is illustrated.

### [Adjustment of Charge Transfer Path]

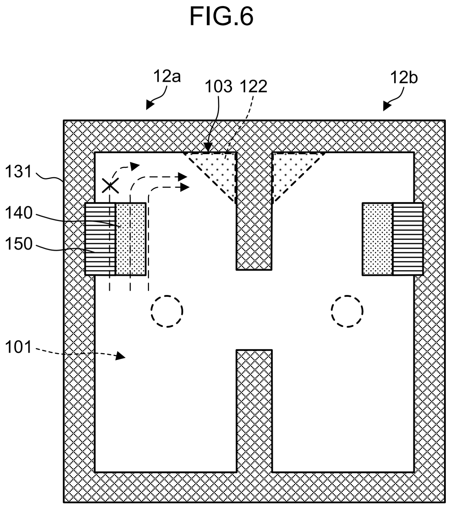

FIG. 6 is a diagram illustrating an example of adjustment of a charge transfer path according to the first embodiment of the present disclosure. FIG. 6 is a plan view illustrating an example of the pixel 12, and is a diagram in which the pixel 12 (pixels 12a and 12b) in FIG. 4 is simplified. The transfer gate 140 and the transfer path adjustment section 150 are illustrated in the pixel 12 of FIG. 6. Furthermore, in the pixel 12 of FIG. 6, the semiconductor region 122 constituting the charge holding section 103 is further described. Adjustment of the charge transfer path by the transfer path adjustment section 150 will be described using FIG. 6.

As described above, when an on-voltage is applied to the transfer gate 140 of the charge transfer section 102, the semiconductor substrate 11 in the vicinity of the transfer gate 140 changes to n-type, and a channel is formed. This channel serves as a charge transfer path. The charge transfer path is formed from the bottom surface to the side surface of the transfer gate 140. Furthermore, the charge transfer path is not uniformly formed on the semiconductor substrate 11 facing the transfer gate 140, but includes a plurality of branched paths. As described above, the charge transfer path of the charge transfer section 102 has a complicated shape unlike a flat plate gate MOS transistor such as the reset transistor 104 in FIG. 5.

In addition, the size (area) of the pixel 12 has been reduced with the miniaturization of the photodetection apparatus 1 in recent years. Therefore, the size of the photoelectric conversion section 101 is also reduced. In order to secure the saturation charge amount in the photoelectric conversion section 101, it is necessary to increase (deepen) the potential of the photoelectric conversion section 101. Normally, the region having a deep potential is formed in the central portion of the photoelectric conversion section 101. Dotted circles in FIG. 6 represent regions where the potential is deep. A large amount of charge is accumulated in the region. The charge transfer section 102 transfers the charge in this region to the charge holding section 103 by deepening its own potential at the time of transfer of the charge. However, in a case where the potential of the charge transfer section 102 at the time of conduction is not sufficiently deep with respect to the potential of the photoelectric conversion section 101, a potential barrier remains, and thus, charge may be retained depending on a charge transfer path, and the charge may not reach the charge holding section 103. For this reason, the charge transfer efficiency decreases. This decrease in charge transfer efficiency occurs significantly in a state where the charge of the photoelectric conversion section 101 is small, such as imaging in a low-illuminance environment.

Furthermore, since the charge transfer path of the transfer gate 140 is different for each pixel 12, the transfer efficiency and the threshold value vary, and an error occurs in the signal level of the generated image signal.

Therefore, the transfer path adjustment section 150 is arranged to adjust the charge transfer path. Specifically, the transfer path adjustment section 150 is arranged adjacent to the side surface of the transfer gate 140. As a result, the charge transfer path is limited to the side surface and the bottom surface of the transfer gate 140 on which the transfer path adjustment section 150 is not arranged, and the transfer path is adjusted. Dotted arrows in FIG. 6 represent the charge transfer paths. The charge transfer path is limited to a path passing through a side surface or a bottom surface not in contact with the transfer path adjustment section 150 of the transfer gate 140. As a result, the charge flowing through the limited charge transfer path increases, and the charge passing through the path that generates the potential barrier decreases.

In addition, by disposing the transfer path adjustment section 150, which is an insulator, on the side surface of the transfer gate 140, the parasitic capacitance of the transfer gate 140 can be reduced.

Note that the transfer path adjustment section 150 in FIG. 6 illustrates an example in which a part is embedded in the separation section 131. Furthermore, the transfer gate 140 is preferably arranged between the central portion of the pixel 12, which is a region where the potential of the photoelectric conversion section 101 is deep, and the charge holding section 103.

### [Method for Manufacturing Photodetection Apparatus]

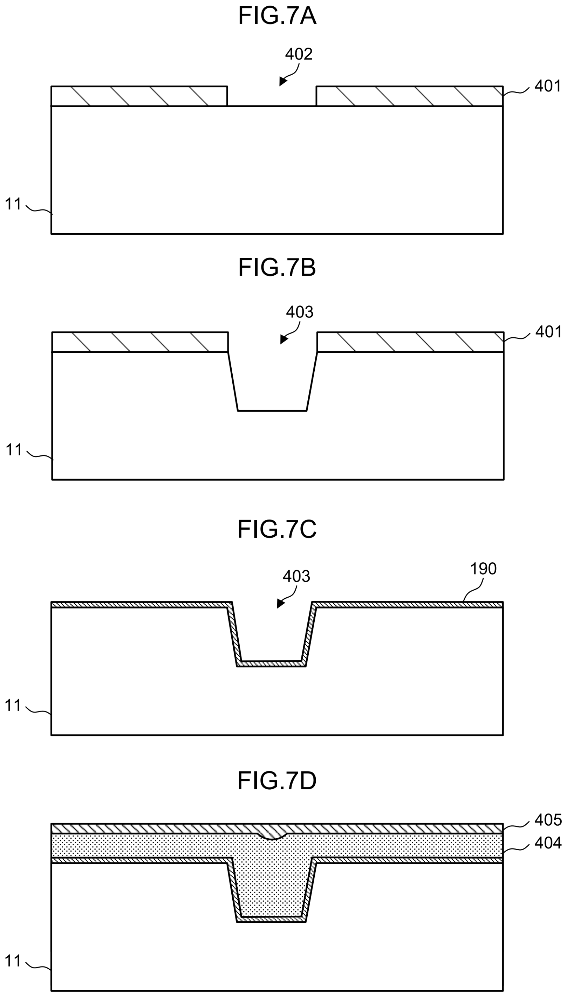

FIGS. 7A to 7G are diagrams illustrating an example of a method for manufacturing the photodetection apparatus according to the first embodiment of the present disclosure. FIGS. 7A to 7G are diagrams illustrating a manufacturing process of the transfer gate 140 and the transfer path adjustment section 150 in the manufacturing process of the photodetection apparatus 1. First, a resist 401 is disposed on the semiconductor substrate 11. In the resist 401, an opening 402 is formed in a region where the transfer gate 140 and the transfer path adjustment section 150 are arranged (FIG. 7A).

Next, a recess 403 is formed on the surface of the semiconductor substrate 11 (FIG. 7B). This can be performed by etching the surface of the semiconductor substrate 11 using the resist 401 as a mask.

Next, the insulating film 190 is formed on the surface of the semiconductor substrate 11 including the recess 403 (FIG. 7C). This can be performed by thermally oxidizing the surface of the semiconductor substrate 11.

Next, a material film 404 and an oxide film 405 (not illustrated in FIG. 5) of the transfer gate 140 are laminated on the surface of the semiconductor substrate 11 including the recess 403 (FIG. 7D). The material film 404 can be constituted by polycrystalline silicon. Further, the oxide film 405 can be constituted by non doped Silicate Glass (NSG).

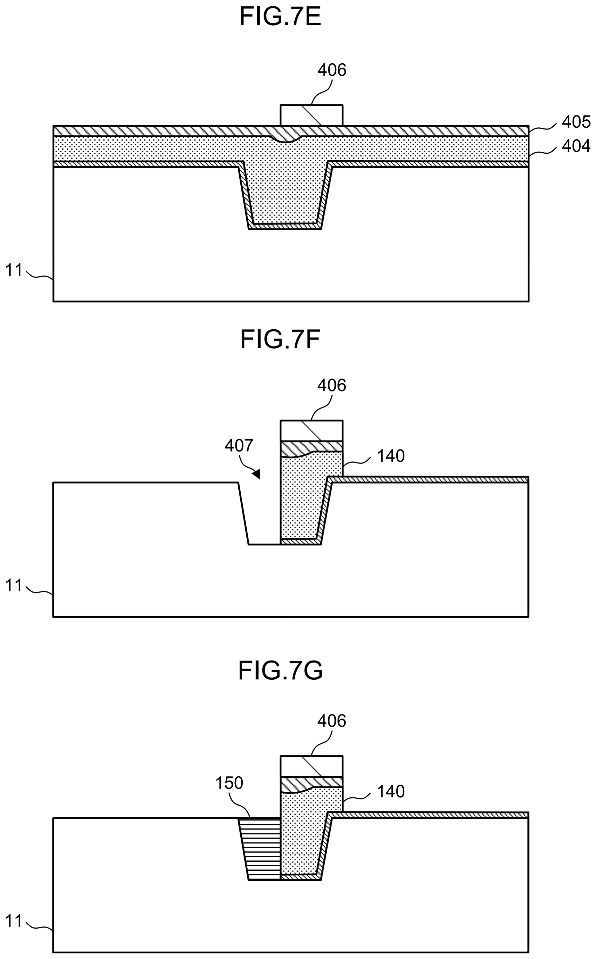

Next, a resist 406 is disposed on the surface of the semiconductor substrate 11. The resist 406 is arranged in a region where the transfer gate 140 is formed (FIG. 7E).

Next, the transfer gate 140 is formed (FIG. 7F). This can be performed by etching the material film 404 and the oxide film 405 using the resist 406 as a mask. In addition, a recess 407 in which the transfer path adjustment section 150 is disposed can be formed by this etching.

Next, the transfer path adjustment section 150 is formed (FIG. 7G). This can be performed by disposing an insulator in the recess 407. Through the above steps, the transfer gate 140 and the transfer path adjustment section 150 can be manufactured.

Furthermore, by applying the above-described manufacturing process, the transfer path adjustment section 150 can be embedded in the region of the transfer gate 140. As a result, the transfer gate 140 can be reduced, and the capacitance of the transfer gate 140 can be reduced.

As described above, in the photodetection apparatus 1 according to the first embodiment of the present disclosure, the transfer path adjustment section 150 is arranged adjacent to the transfer gate 140 of the charge transfer section 102. Since no transfer path is generated on the side surface of the transfer gate 140 adjacent to the transfer path adjustment section 150, the charge transfer path can be limited. By arranging the transfer path adjustment section 150 in this manner, the transfer path of the charge transfer section 102 can be adjusted. As a result, the charge transfer path is simplified, and a decrease in charge transfer efficiency can be prevented.

### (2. Second Embodiment)

Variations of the transfer gate 140 and the transfer path adjustment section 150 according to the first embodiment described above will be described.

### [Configuration of Pixel]

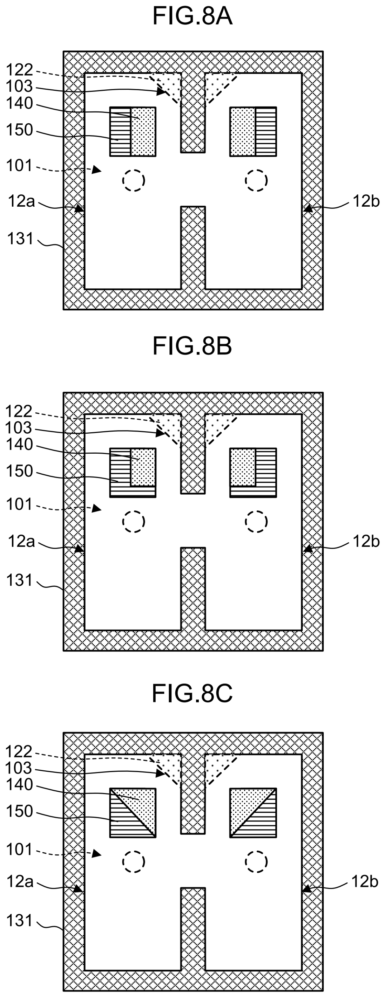

FIGS. 8A to 8C are diagrams illustrating a configuration example of a pixel according to a second embodiment of the present disclosure. FIGS. 8A to 8C are simplified diagrams of the pixel 12 in FIG. 4. Furthermore, the pixel 12 in FIGS. 8A to 8C is different from the pixel 12 in FIG. 4 in that the transfer path adjustment section 150 is arranged to be separated from the separation section 131. FIG. 8A illustrates an example in which the transfer path adjustment section 150 is configured to have a shape in contact with one side surface of the transfer gate 140. FIG. 8B illustrates an example in which the transfer path adjustment section 150 is configured to have a shape in contact with two adjacent side surfaces of the transfer gate 140. FIG. 8C illustrates an example of the transfer gate 140 and the transfer path adjustment section 150 configured in a triangular shape in plan view.

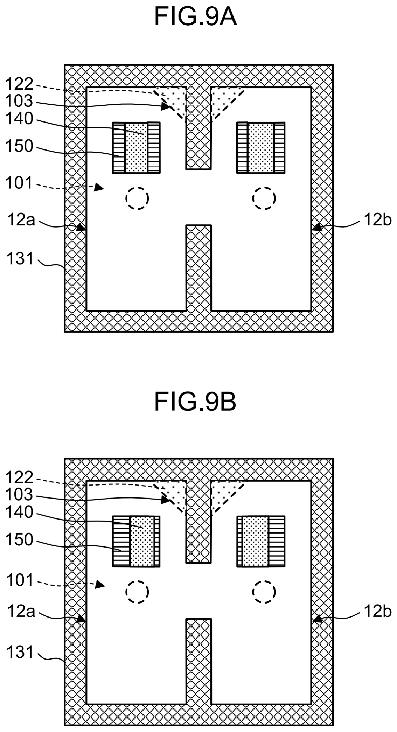

FIGS. 9A and 9B are diagrams illustrating another configuration example of the pixel according to the second embodiment of the present disclosure. FIGS. 9A and 9B illustrate an example in which two transfer path adjustment sections 150 are arranged on both sides of the transfer gate 140. Note that it is also possible to adopt a configuration in which three or more transfer path adjustment sections 150 are arranged.

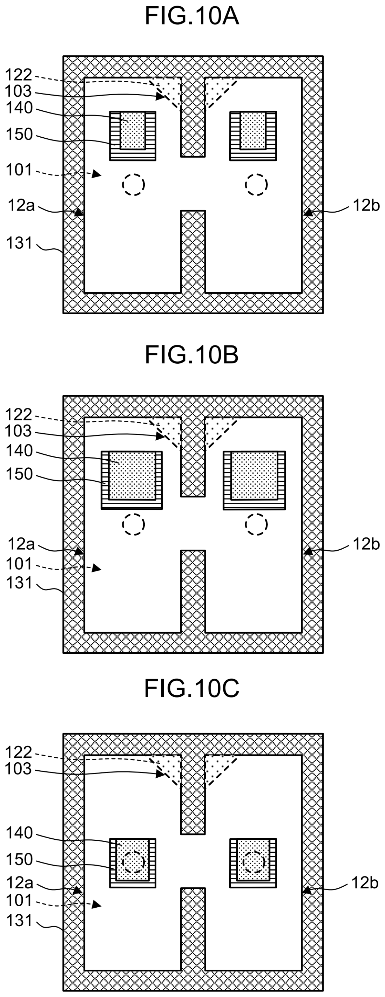

FIGS. 10A to 10C are diagrams illustrating a configuration example of a pixel according to the second embodiment of the present disclosure. FIGS. 10A to 10C illustrate an example in which the transfer path adjustment section 150 is configured to have a shape in contact with three side surfaces of the transfer gate 140. Note that FIG. 10C illustrates an example in which the transfer gate 140 is arranged in the central portion of the pixel 12.

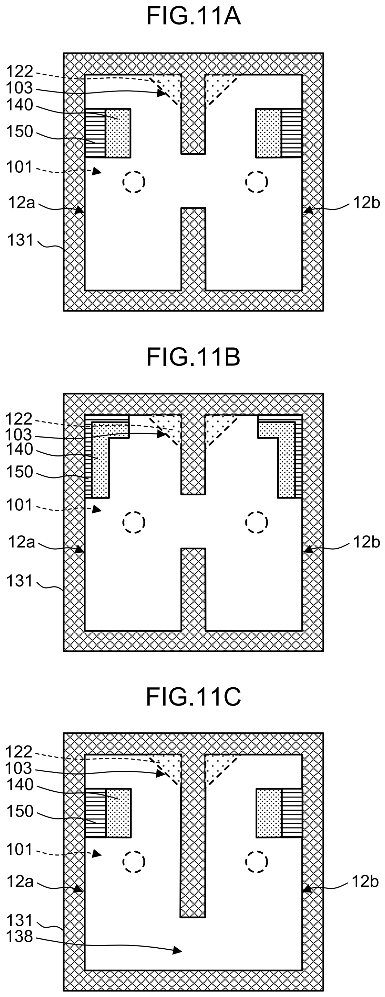

FIGS. 11A to 11C are diagrams illustrating a configuration example of a pixel according to the second embodiment of the present disclosure. FIGS. 11A to 11C illustrate an example in which the transfer path adjustment section 150 is configured to have a shape in contact with the separation section 131. FIG. 11A illustrates an example in which the transfer path adjustment section 150 is configured to have a shape in contact with one surface of the separation section 131. FIG. 11B illustrates an example in which the transfer path adjustment section 150 is configured to have a shape in contact with two adjacent surfaces of the separation section 131. FIG. 11C illustrates an example in which the opening 138 of the separation section 131 is formed at a position different from that of the pixel 12 in FIG. 11A.

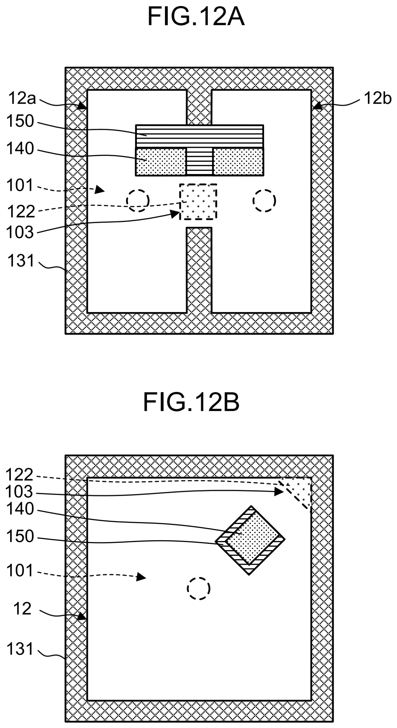

FIGS. 12A and 12B are diagrams illustrating another configuration example of the pixel according to the second embodiment of the present disclosure. FIG. 12A illustrates an example in which the transfer path adjustment section 150 is commonly arranged in the adjacent pixel 12a and pixel 12b. FIG. 12B illustrates an example in which the transfer gate 140 and the transfer path adjustment section 150 are arranged in the pixel 12 having a square shape in plan view.

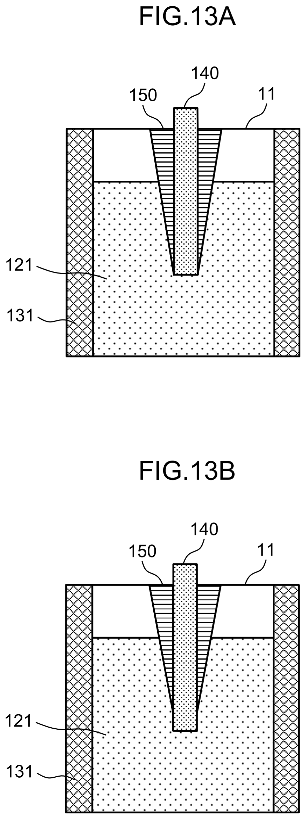

FIGS. 13A and 13B are diagrams illustrating another configuration example of the pixel according to the second embodiment of the present disclosure. FIGS. 13A and 13B illustrate the shape of the transfer path adjustment section 150 in the depth direction. FIG. 13A illustrates an example in which the bottom portion of the transfer path adjustment section 150 is configured to have substantially the same depth as the bottom portion of the transfer gate 140. FIG. 13B illustrates an example in which the bottom portion of the transfer path adjustment section 150 is configured to be at a position shallower than the bottom portion of the transfer gate 140. The bottom portion of the transfer path adjustment section 150 only needs to be in the vicinity of the bottom portion of the transfer gate 140, and the bottom portion of the transfer path adjustment section 150 does not necessarily have to have the same depth as the bottom portion of the transfer gate 140. Also in the case of FIG. 13B, the charge transfer path of the transfer gate 140 can be limited by the transfer path adjustment section 150.

Since the configuration of the photodetection apparatus 1 other than this is similar to the configuration of the photodetection apparatus 1 in the first embodiment of the present disclosure, the description thereof will be omitted.

### (3. Third Embodiment)

In the photodetection apparatus 1 of the first embodiment described above, the charge transfer path of the charge transfer section 102 is adjusted by the transfer path adjustment section 150. On the other hand, a photodetection apparatus 1 according to a third embodiment of the present disclosure is different from that of the above-described first embodiment in that a charge transfer path is adjusted by changing a shape of the transfer gate 140 of the charge transfer section 102.

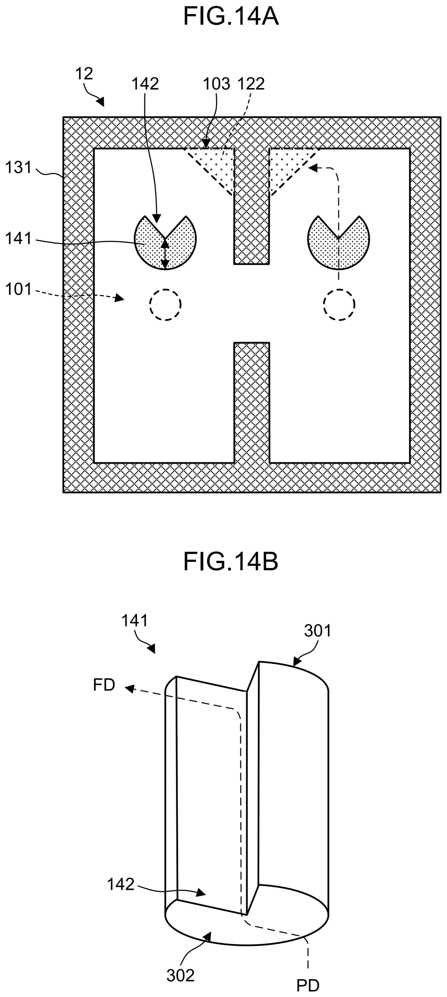

FIG. 14A is a diagram illustrating a configuration example of a pixel according to the third embodiment of the present disclosure. FIG. 14A is a diagram illustrating a shape of the transfer gate 141 according to the third embodiment of the present disclosure. The transfer gate 141 of FIG. 14A is formed in a circular shape in plan view, and a notch portion 142 having a fan-shaped cross section is disposed at the bottom portion. A region shortened with respect to the charge transfer direction is formed on the bottom surface of the transfer gate 141 by the notch portion 142. The arrows in FIG. 14A represent regions of the shortened bottom surface. Since the charge transfer distance is shortened in this region, the charge transfer path can be limited to a shortened region on the bottom surface of the transfer gate 141. In the transfer gate 141 of FIG. 14A, the charge transfer path is limited and adjusted by the notch portion 142.

FIG. 14B is a diagram illustrating a configuration example of a transfer gate according to the third embodiment of the present disclosure. FIG. 14B is a schematic diagram illustrating a configuration example of the transfer gate 141. The notch portion 142 can be formed on a side surface from a bottom surface 302 to an upper surface 301 of the transfer gate 141. A dotted arrow in FIG. 14B represents the adjusted charge transfer path. Note that "PD" and "FD" in FIG. 14B represent the positions of the photoelectric conversion section 101 and the charge holding section 103, respectively. The charge of the photoelectric conversion section 101 moves to the side surface of the notch portion 142 via the shortened region of the bottom surface 302 of the transfer gate 141 described above. Since the cross section of the notch portion 142 is a fan shape, two end portions of the transfer gate 141 separated by the notch portion 142 are formed. Since the potential of the region sandwiched between the two end portions is modulated, the charge moves to the front surface side of the semiconductor substrate 11 along the end portion of the notch portion 142 which is the region sandwiched between the two end portions. In this manner, the charge transfer path is adjusted by the notch portion 142.

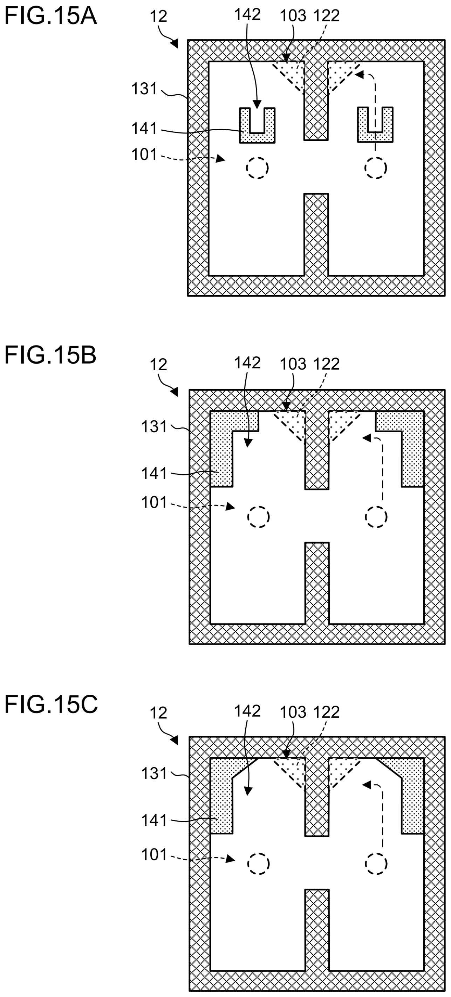

FIGS. 15A to 15B are diagrams illustrating another configuration example of the pixel according to the third embodiment of the present disclosure. FIGS. 15A to 15B are diagrams illustrating another configuration example of the transfer gate 141 according to the third embodiment of the present disclosure. In FIGS. 15A to 15B, a dotted arrow represents a charge transfer path.

FIG. 15A illustrates an example in which the rectangular notch portion 142 is arranged on a side surface of the rectangular transfer gate 141 in plan view. FIG. 15B illustrates an example in which the transfer gate 141 is configured to have a shape in contact with two adjacent surfaces of the separation section 131. The notch portion 142 can be formed in a region separated from the separation section 131 of the transfer gate 141. FIG. 15C illustrates an example in which an inclined surface is formed in the vicinity of the charge holding section 103 while having a shape similar to that of the transfer gate 141 in FIG. 15B.

Since the configuration of the photodetection apparatus 1 other than this is similar to the configuration of the photodetection apparatus 1 in the first embodiment of the present disclosure, the description thereof will be omitted.

As described above, the photodetection apparatus 1 according to the third embodiment of the present disclosure can adjust the charge transfer path by arranging the notch portion 142 in the transfer gate 141 of the charge transfer section 102.

### (4. Fourth Embodiment)

As described above, the solid-state imaging apparatus of Patent Literature 1 includes the transistor that transfers the charge generated by the photoelectric conversion section (photodiode) in the thickness direction of the semiconductor substrate. A columnar gate electrode is disposed in the transistor. Normally, the gate electrode is constituted by polycrystalline silicon containing impurities. Specifically, the gate electrode can be formed by adding impurities to polycrystalline silicon configured in a predetermined shape by ion implantation. However, the above-described columnar gate electrode has a problem that impurities cannot reach the bottom portion and the resistance cannot be sufficiently reduced. For this reason, the charge transfer efficiency in the charge transfer section decreases.

Therefore, a fourth embodiment of the present disclosure proposes a photodetection apparatus that prevents a decrease in charge transfer efficiency by reducing the resistance of the gate electrode of the charge transfer section.

### [Configuration of Pixel]

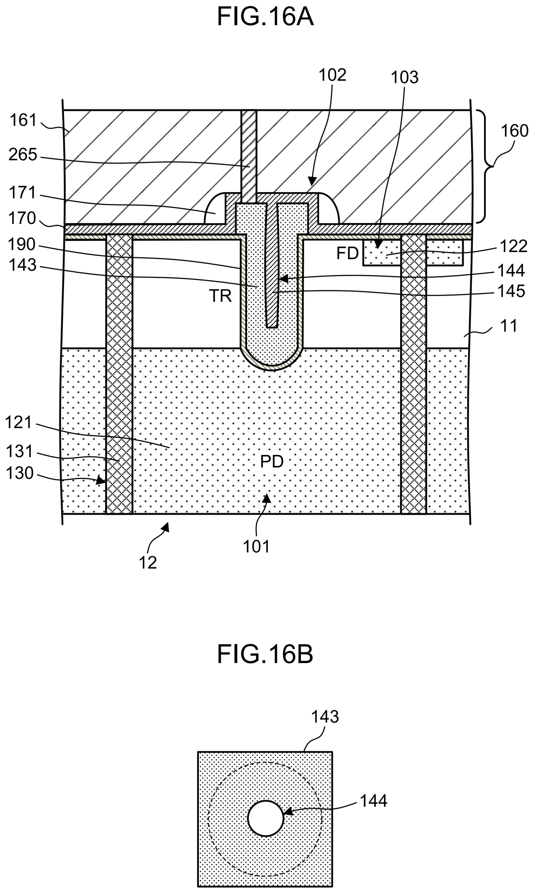

FIG. 16A is a diagram illustrating a configuration example of a pixel according to the fourth embodiment of the present disclosure. Similarly to FIG. 5, FIG. 16A is a cross-sectional view illustrating a configuration example of the pixel 12 in the pixel array section 13. For convenience, FIG. 16A illustrates a portion of the semiconductor substrate 11 in the pixel 12 in a simplified manner.

The charge transfer section 102 in FIG. 16A includes a transfer gate 143. The transfer gate 143 is different from the transfer gate 140 in FIG. 5 in that a recess 144 is formed in a central portion. Note that the transfer gate 143 in FIG. 16A illustrates an example in which a sidewall 171 is disposed. In addition, a protective film 170 is disposed on the front surface side of the semiconductor substrate 11 including the transfer gate 143 in FIG. 16A. The protective film 170 corresponds to a passivation film.

The recess 144 can be formed at a depth reaching the vicinity of the bottom portion of the transfer gate 143. By performing ion implantation of impurities after the formation of the recess 144, impurities can be implanted into a deep region of the transfer gate 143. As a result, the resistance of the bottom portion of the transfer gate 143 can be reduced. Note that a filling portion 145 is disposed in the recess 144. The filling portion 145 can be constituted by, for example, an insulator such as SiO₂. FIG. 16A illustrates an example in which the filling portion 145 is constituted by the same material as the protective film 170. In addition, the filling portion 145 can also be constituted by a conductor such as metal.

As illustrated in FIG. 16A, the through wiring 265 connected to the transfer gate 143 can be arranged at a position not overlapping with the recess 144. As a result, an increase in the resistance of the connection portion between the through wiring 265 and the transfer gate 143 can be prevented.

FIG. 16B is a diagram illustrating a configuration example of a transfer gate according to the fourth embodiment of the present disclosure. FIG. 16B is a plan view illustrating a configuration example of the transfer gate 143. An example in which the transfer gate 143 of FIG. 16B is configured in a rectangular shape in plan view is illustrated. In addition, an example in which the recess 144 has a circular opening is illustrated. Note that the broken line in FIG. 16B represents the shape of the transfer gate 143 in the region inside the semiconductor substrate 11.

### [Method for Manufacturing Photodetection Apparatus]

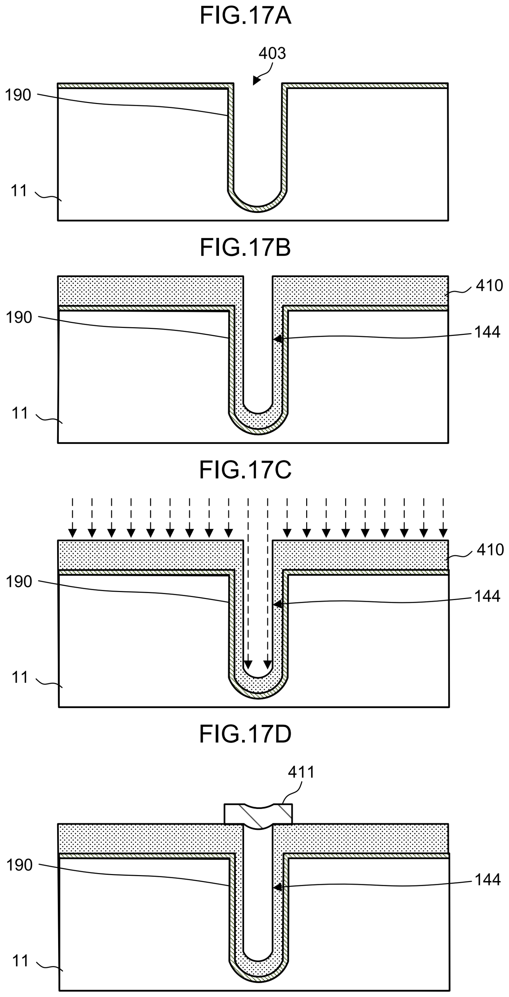

FIGS. 17A to 17G are diagrams illustrating an example of a method for manufacturing the photodetection apparatus according to the fourth embodiment of the present disclosure. FIGS. 17A to 17G are diagrams illustrating a manufacturing process of the transfer gate 143 in the manufacturing process of the photodetection apparatus 1. First, the recess 403 is formed on the surface of the semiconductor substrate 11, and the insulating film 190 is disposed (FIG. 17A). This can be performed by the steps illustrated in FIGS. 7A to 7C.

Next, the material film 410 of the transfer gate 143 is disposed on the surface of the semiconductor substrate 11 including the inner wall of the recess 403 (FIG. 17B). The material film 410 is constituted by polycrystalline silicon. In this step, the recess 144 is formed.

Next, ion implantation of impurities is performed on the material film 410. For example, boron (B) can be applied as the impurity to be implanted. FIG. 17C is a diagram illustrating a state of ion implantation. The dotted arrows in FIG. 17C indicate the trajectories of the implanted impurity ions. Since the recess 144 is disposed, a sufficient amount of impurities is also implanted into the material film 410 at the bottom portion of the recess 403.

Next, a resist 411 is formed on the surface of the material film 410 (FIG. 17D). The resist 411 can be formed in a shape that covers the recess 403.

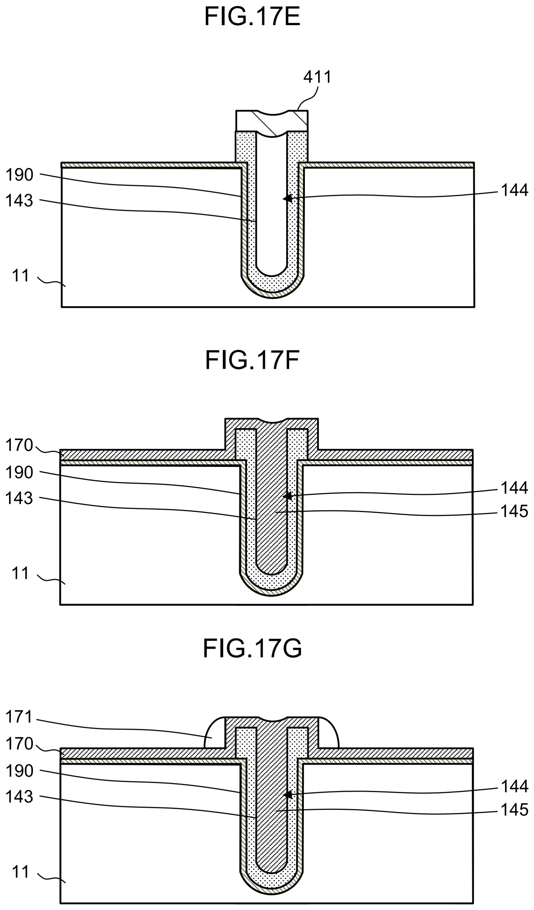

Next, the transfer gate 143 is formed (FIG. 17E). This can be performed by etching the material film 410 using the resist 411 as a mask. Thereafter, the resist 411 is removed.

Next, an insulator film is formed on the surface of the semiconductor substrate 11 including the recess 144, and the protective film 170 and the filling portion 145 are formed (FIG. 17F).

Thereafter, the sidewall 171 is formed (FIG. 17G). Through the above steps, the transfer gate 143 can be manufactured.

Since the configuration of the photodetection apparatus 1 other than this is similar to the configuration of the photodetection apparatus 1 in the first embodiment of the present disclosure, the description thereof will be omitted.

As described above, the photodetection apparatus 1 according to the fourth embodiment of the present disclosure can reduce the resistance of the transfer gate 143 by forming the recess 144 in the central portion of the transfer gate 143 of the charge transfer section 102 and performing ion implantation. This makes it possible to prevent a decrease in charge transfer efficiency of the charge transfer section 102.

### (5. Fifth Embodiment)

A variation of the transfer gate 143 of the above-described fourth embodiment will be described.

### [Configuration of Transfer Gate]

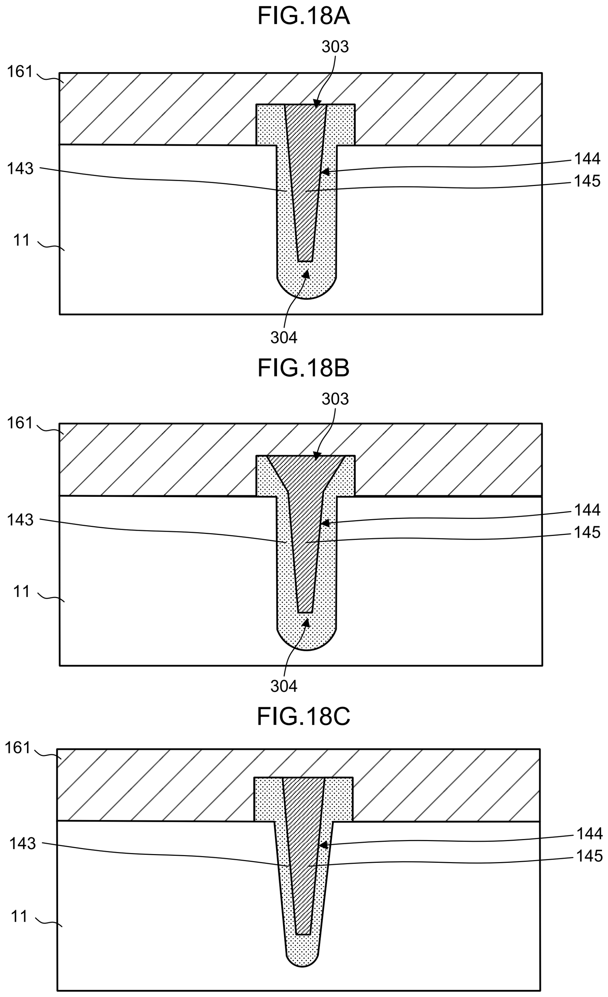

FIGS. 18A to 18C are diagrams illustrating a configuration example of a transfer gate according to a fifth embodiment of the present disclosure. FIGS. 18A to 18C illustrate an example of the tapered recess 144. FIG. 18A illustrates an example in which the opening width of an opening 303 of the recess 144 is configured to be larger than the width of the bottom portion 304. FIG. 18B illustrates an example in which the vicinity of the opening 303 of the recess 144 is formed at a taper angle different from the vicinity of the bottom portion 304. FIG. 18C illustrates an example in which the transfer gate 143 is also configured in a tapered shape. By forming the inner wall of the recess 144 in a tapered shape, impurity ions incident in the normal direction of the semiconductor substrate 11 at the time of ion implantation can be made incident on the transfer gate 143 on the side surface of the recess 144. As a result, the resistance value of the transfer gate 143 can be made uniform, and the resistance of the transfer gate 143 can be further reduced.

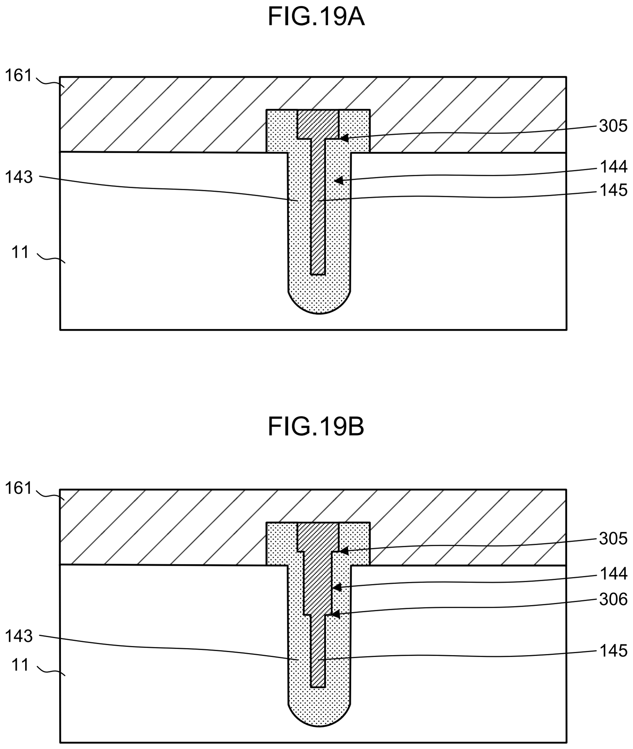

FIGS. 19A and 19B are diagrams illustrating another configuration example of the transfer gate according to the fifth embodiment of the present disclosure. FIGS. 19A and 19B illustrate examples of the recess 144 in which a step is formed. FIG. 19A illustrates an example of the recess 144 in which one step (step 305) is formed. In addition, FIG. 19B illustrates an example of the recess 144 in which a plurality of steps (steps 305 and 306) is formed. By forming the step on the inner wall of the recess 144, impurity ions incident in the normal direction of the semiconductor substrate 11 at the time of ion implantation can be incident on the transfer gate 143 at the step portion of the recess 144. The resistance of the transfer gate 143 can be further reduced.

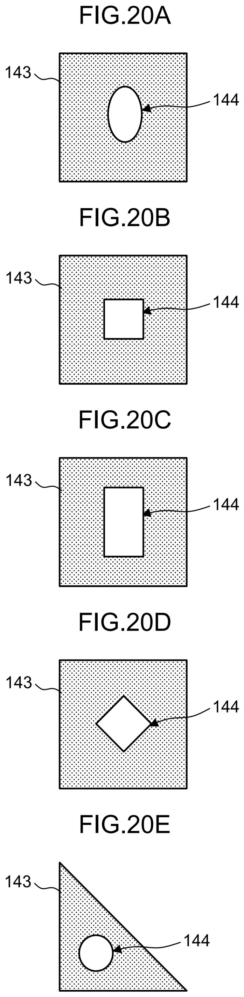

FIGS. 20A to 20E are diagrams illustrating another configuration example of the transfer gate according to the fifth embodiment of the present disclosure. FIGS. 20A to 20E illustrate variations of the shape of the opening of the recess 144. FIG. 20A illustrates an example of the recess 144 in which the opening is formed in an elliptical shape. FIGS. 20B to 20D illustrate an example of the recess 144 in which the opening is formed in a rectangular shape. FIG. 20E illustrates an example of the transfer gate 143 configured in a triangular shape in plan view.

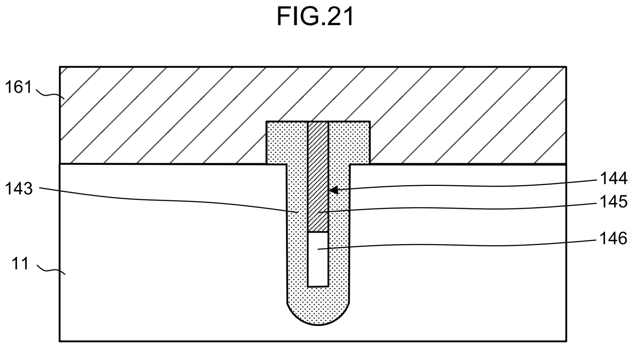

FIG. 21 is a diagram illustrating another configuration example of the transfer gate according to the fifth embodiment of the present disclosure. FIG. 21 illustrates an example in which a void 146 is formed in the recess 144. The void 146 in FIG. 21 is an example formed in the vicinity of the bottom portion of the recess 144. The void 146 can be, for example, in a vacuum state. The incident light transmitted through the photoelectric conversion section 101 can be diffused by the void 146 to contribute to photoelectric conversion. As a result, the sensitivity of the pixel 12 can be improved.

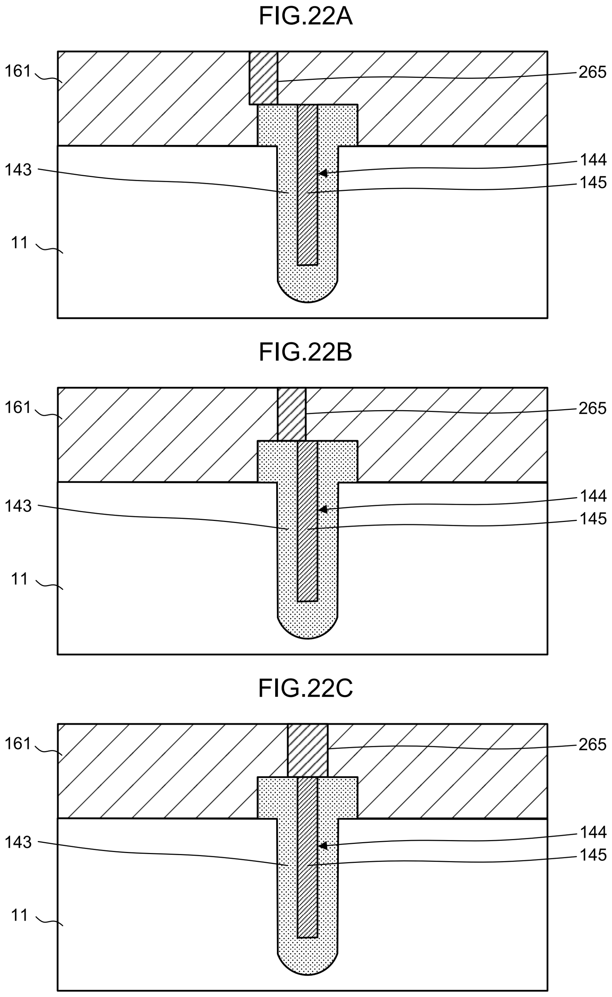

FIGS. 22A to 22C are diagrams illustrating another configuration example of the transfer gate according to the fifth embodiment of the present disclosure. FIGS. 22A to 22C illustrate variations of the through wiring 265 connected to the transfer gate 143. FIG. 22A illustrates an example in which the through wiring 265 is connected to the end portion of the transfer gate 143. FIG. 22B illustrates an example in which the through wiring 265 is connected to a position covering the recess 144. FIG. 22C illustrates an example in which the through wiring 265 having a bottom surface larger than the opening diameter of the recess 144 is used, and the through wiring 265 is disposed at a position to close the recess 144.

Since the configuration of the photodetection apparatus 1 other than this is similar to the configuration of the photodetection apparatus 1 in the fourth embodiment of the present disclosure, the description thereof will be omitted.

### (6. Configuration of Electronic Device)

The photodetection apparatus 1 as described above can be applied to various electronic devices such as an imaging system such as a digital still camera or a digital video camera, a mobile phone having an imaging function, or another device having an imaging function.

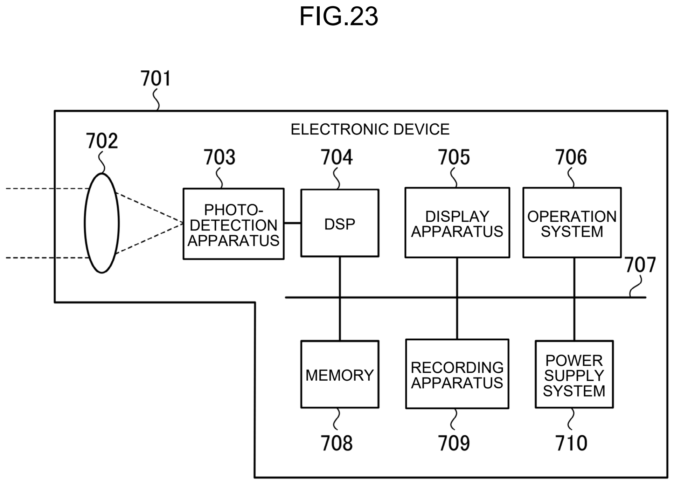

FIG. 23 is a block diagram illustrating a configuration example of an imaging apparatus mounted on an electronic device. As illustrated in FIG. 23, an electronic device 701 includes an optical system 702, a photodetection apparatus 703, and a digital signal processor (DSP) 704, and is configured by connecting a DSP 704, a display apparatus 705, an operation system 706, a memory 708, a recording apparatus 709, and a power supply system 710 via a bus 707, and is capable of capturing a still image and a moving image.

The optical system 702 includes one or a plurality of lenses, guides image light (incident light) from a subject to the photodetection apparatus 703, and forms an image on a light receiving surface (sensor section) of the photodetection apparatus 703.

As the photodetection apparatus 703, the photodetection apparatus 1 of any of the above-described configuration examples is applied. In the photodetection apparatus 703, electrons are accumulated for a certain period according to an image formed on the light receiving surface via the optical system 702. Then, a signal corresponding to the electrons accumulated in the photodetection apparatus 703 is input to the DSP 704.

The DSP 704 performs various types of signal processing on the signal from the photodetection apparatus 703 to acquire an image, and temporarily stores data of the image in the memory 708. The image data stored in the memory 708 is recorded in the recording apparatus 709 or supplied to the display apparatus 705 to display an image. In addition, the operation system 706 receives various operations by the user and supplies an operation signal to each block of the electronic device 701, and the power supply system 710 supplies power necessary for driving each block of the electronic device 701.

### (7. Example of application to mobile body)

The technology according to the present disclosure (the present technology) is applicable to various products. For example, the technology according to the present disclosure may be applied to devices mounted on any of mobile body such as automobiles, electric vehicles, hybrid electric vehicles, motorcycles, bicycles, personal mobility, airplanes, drones, ships, and robots.

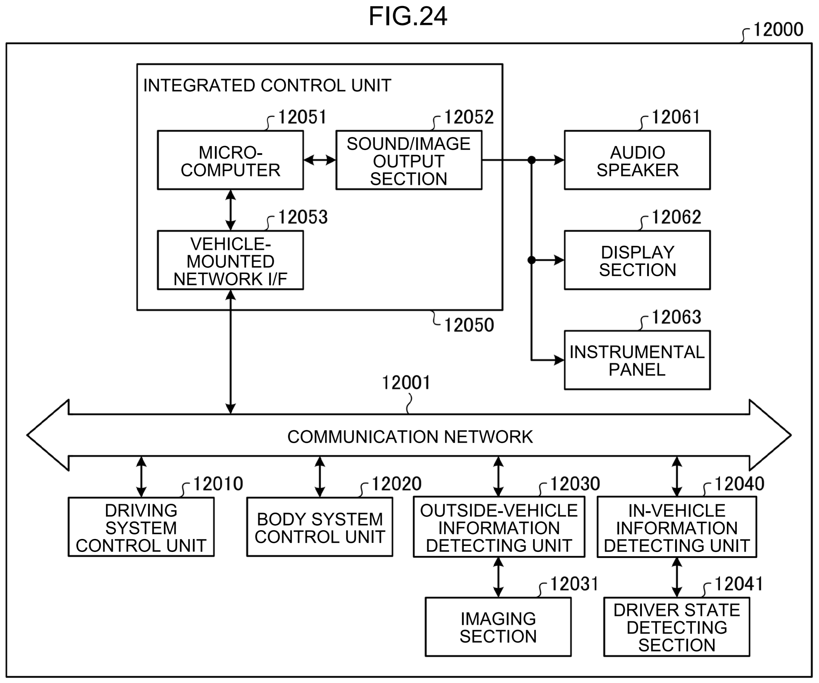

FIG. 24 is a block diagram depicting an example of schematic configuration of a vehicle control system as an example of a mobile body control system to which the technology according to an embodiment of the present disclosure can be applied.

A vehicle control system 12000 includes a plurality of electronic control units connected to each other via a communication network 12001. In the example depicted in FIG. 24, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 24, an audio speaker 12061, a display section 12062, and an instrument panel 12063 are illustrated as the output device. The display section 12062 may, for example, include at least one of an on-board display and a head-up display.

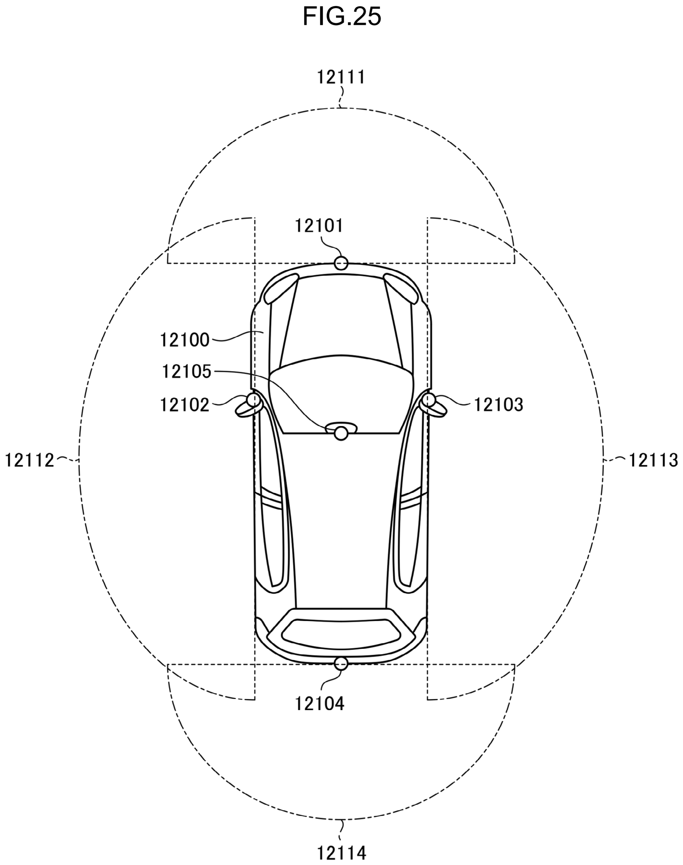

FIG. 25 is a diagram depicting an example of the installation position of the imaging section 12031.

In FIG. 25, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of a vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 25 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of the vehicle control system to which the technology according to the present disclosure can be applied has been described above. The technology according to the present disclosure can be applied to the imaging section 12031 among the configurations described above. Specifically, the photodetection apparatus 1 of FIG. 1 can be applied to the imaging section 12031.

### (8. Example of application to endoscopic surgery system)

The technology according to the present disclosure (the present technology) is applicable to various products. For example, the techniques according to the present disclosure may be applied to endoscopic surgery systems.

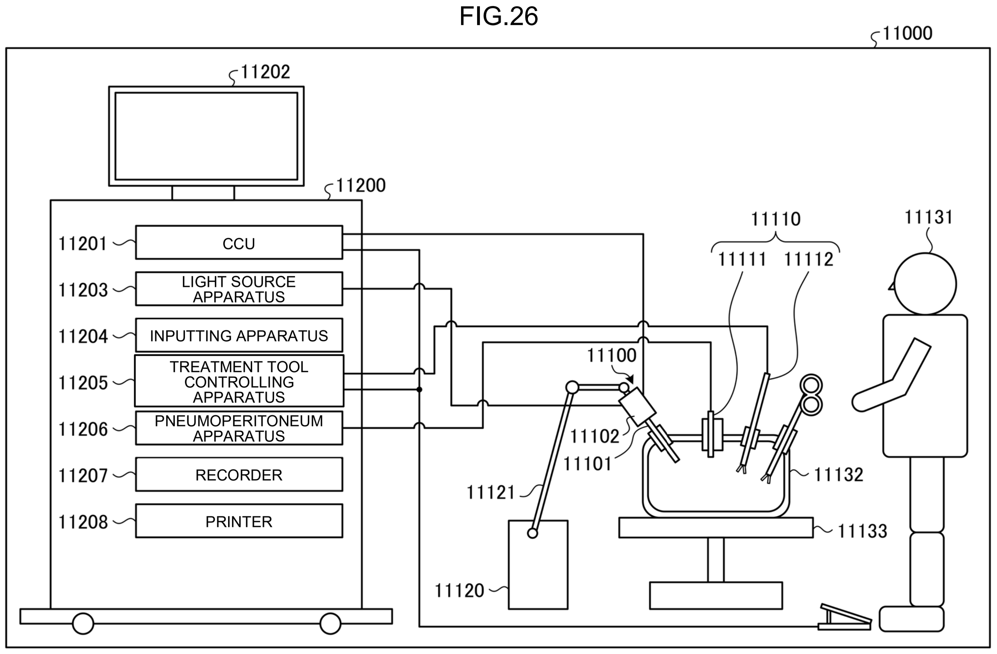

FIG. 26 is a view depicting an example of a schematic configuration of an endoscopic surgery system to which the technology according to an embodiment of the present disclosure (present technology) can be applied.

In FIG. 26, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy treatment tool 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body lumen of the patient 11132, and a camera head 11102 connected to a proximal end of the lens barrel 11101. In the example depicted, the endoscope 11100 is depicted which includes as a hard mirror having the lens barrel 11101 of the hard type. However, the endoscope 11100 may otherwise be included as a soft mirror having the lens barrel 11101 of the soft type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body lumen of the patient 11132 through the objective lens. It is to be noted that the endoscope 11100 may be a direct view mirror or may be a perspective view mirror or a side view mirror.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy treatment tool 11112 for cautery or incision of a tissue, sealing of a blood vessel or the like. A pneumoperitoneum apparatus 11206 feeds gas into a body lumen of the patient 11132 through the pneumoperitoneum tube 11111 to inflate the body lumen in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrowband light and/or excitation light suitable for special light observation as described above.

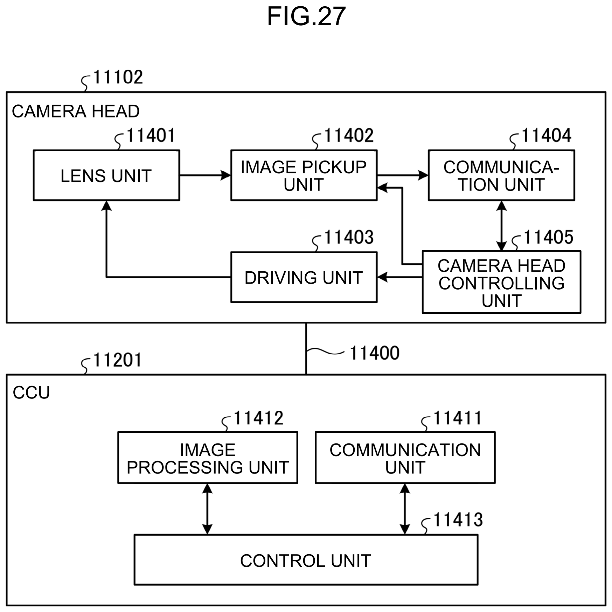

FIG. 27 is a block diagram depicting an example of a functional configuration of the camera head 11102 and the CCU 11201 depicted in FIG. 26.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy treatment tool 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

An example of the endoscopic surgery system to which the technology according to the present disclosure can be applied has been described above. The technology according to the present disclosure can be applied to the endoscope 11100 and the image pickup unit 11402 of the camera head 11102 among the above-described configurations. Specifically, the photodetection apparatus 1 of FIG. 1 can be applied to the image pickup unit 11402.

Although the endoscopic surgery system has been described here as an example, the technique according to the present disclosure may be applied to, for example, a microscopic surgery system or the like.

Note that the semiconductor apparatus of the present disclosure can also include a charge transfer section including a MOS transistor that transfers a charge from the second semiconductor region to the first semiconductor region. Specifically, in the charge transfer section 102 of FIG. 5, a MOS transistor that transfers a charge from the semiconductor region 122 to the semiconductor region 121 can be used.

Note that the first, second, and third embodiments of the present disclosure may be combined with the fourth and fifth embodiments of the present disclosure. For example, the recess 144 in FIG. 16A can be applied to the transfer gate 140 in FIG. 5 or the transfer gate 141 in FIG. 14A.

Note that the effects described in the present specification are merely examples and are not limited, and other effects may be provided.

Note that the present technology can also have the following configurations.
(1) A semiconductor apparatus comprising:
   a charge transfer section configured by a MOS transistor including a first semiconductor region disposed in a semiconductor substrate, a second semiconductor region disposed in the vicinity of a surface of the semiconductor substrate, and a transfer gate embedded in the vicinity of the surface of the semiconductor substrate, having a bottom portion formed in the vicinity of the first semiconductor region and being a gate electrode, and configured to transfer a charge from one of the first semiconductor region and the second semiconductor region to the other; and
   a transfer path adjustment section that is disposed adjacent to the transfer gate, has a bottom portion constituted by an insulator formed in the vicinity of the bottom portion of the transfer gate, and adjusts a transfer path of the charge in the charge transfer section.
(2) The semiconductor apparatus according to the above (1), wherein the transfer gate has a shape in which the bottom portion reaches the first semiconductor region.
(3) The semiconductor apparatus according to the above (1) or (2), wherein the charge transfer section is disposed between a central portion of the first semiconductor region and the second semiconductor region in plan view.
(4) The semiconductor apparatus according to any one of the above (1) to (3), further comprising a plurality of the transfer path adjustment section.
(5) The semiconductor apparatus according to any one of the above (1) to (4), further comprising a plurality of pixels including the first semiconductor region, the second semiconductor region, the charge transfer section, and the transfer path adjustment section.
(6) The semiconductor apparatus according to the above (5), wherein the second semiconductor region is disposed at an end portion of the pixel.
(7) The semiconductor apparatus according to the above (5), further comprising a separation section disposed at a boundary between the pixels.
(8) The semiconductor apparatus according to the above (7), wherein the transfer path adjustment section is disposed adjacent to the separation section.
(9) The semiconductor apparatus according to the above (7), wherein
   the pixel is configured in a shape of a rectangle in plan view, and
   the second semiconductor region is disposed at a corner portion of the rectangle.
(10) The semiconductor apparatus according to the above (9), wherein the transfer path adjustment section is disposed at another corner portion adjacent to the corner portion.
(11) The semiconductor apparatus according to any one of the above (1) to (10), further comprising a signal generation section that generates a signal based on the charge held in the second semiconductor region.
(12) A semiconductor apparatus comprising:
   a charge transfer section configured by a MOS transistor including a first semiconductor region disposed in a semiconductor substrate, a second semiconductor region disposed in the vicinity of a surface of the semiconductor substrate, and a transfer gate embedded in the vicinity of the surface of the semiconductor substrate, having a bottom portion formed in the vicinity of the first semiconductor region and being a gate electrode, and configured to transfer a charge from one of the first semiconductor region and the second semiconductor region to the other; and
   a notch portion formed in the bottom portion of the transfer gate.
(13) The semiconductor apparatus according to the above (12), wherein the notch portion is formed along a side surface of the transfer gate.
(14) A semiconductor apparatus comprising:
   a charge transfer section configured by a MOS transistor including a first semiconductor region disposed in a semiconductor substrate, a second semiconductor region disposed in the vicinity of a surface of the semiconductor substrate, and a transfer gate embedded in the vicinity of the surface of the semiconductor substrate, having a bottom portion formed in the vicinity of the first semiconductor region and being a gate electrode, and configured to transfer a charge from one of the first semiconductor region and the second semiconductor region to the other; and
   a recess formed on a front surface side of the transfer gate.
(15) The semiconductor apparatus according to the above (14), wherein the recess is configured to have a tapered cross section.
(16) The semiconductor apparatus according to the above (15), wherein the recess is configured such that the vicinity of an opening portion has a taper angle different from that of the vicinity of a bottom portion.
(17) The semiconductor apparatus according to the above (14), wherein a step is formed in the recess.
(18) The semiconductor apparatus according to any one of the above (14) to (16), wherein the transfer gate has a tapered cross section.
(19) The semiconductor apparatus according to any one of the above (14) to (18), wherein an insulator is disposed in the recess.
(20) The semiconductor apparatus according to any one of the above (14) to (18), wherein a void is formed in the recess.
(21) A photodetection apparatus including:
   a photoelectric conversion section that is disposed in a semiconductor substrate and performs photoelectric conversion of incident light;
   a charge holding section that is disposed in the vicinity of a surface of the semiconductor substrate and holds a charge generated by the photoelectric conversion;
   a charge transfer section configured by a MOS transistor including a transfer gate embedded in the surface of the semiconductor substrate, having a bottom portion formed in the vicinity of the photoelectric conversion section and being a gate electrode, and configured to transfer a charge of the photoelectric conversion section to the charge holding section; and
   a transfer path adjustment section that is disposed adjacent to the transfer gate, has a bottom portion constituted by an insulator formed in the vicinity of the bottom portion of the transfer gate, and adjusts a transfer path of the charge in the charge transfer section.
(22) The photodetection apparatus according to (21), in which the transfer gate has a shape in which the bottom portion reaches the photoelectric conversion section.
(23) The photodetection apparatus according to (21) or (22), in which the charge transfer section is disposed between a central portion of the photoelectric conversion section and the charge holding section in plan view.
(24) The photodetection apparatus according to any one of (21) to (23), further including a plurality of the transfer path adjustment section.
(25) The photodetection apparatus according to any one of (21) to (24), further including a plurality of pixels including the photoelectric conversion section, the charge holding section, the charge transfer section, and the transfer path adjustment section.
(26) The photodetection apparatus according to (25), in which the charge holding section is disposed at an end portion of the pixel.
(27) The photodetection apparatus according to (25), further including a separation section disposed at a boundary between the pixels.
(28) The photodetection apparatus according to (27), in which the transfer path adjustment section is disposed adjacent to the separation section.
(29) The photodetection apparatus according to (27), in which
   the pixel is configured in a shape of a rectangle in plan view, and
   the charge holding section is disposed at a corner portion of the rectangle.
(30) The photodetection apparatus according to (29), in which the transfer path adjustment section is disposed at another corner portion adjacent to the corner portion.
(31) The photodetection apparatus according to any one of (21) to (30), further including a signal generation section that generates a signal based on the charge held.
(32) A photodetection apparatus including:
   a photoelectric conversion section that is disposed in a semiconductor substrate and performs photoelectric conversion of incident light;
   a charge holding section that is disposed in the vicinity of a surface of the semiconductor substrate and holds a charge generated by the photoelectric conversion;
   a charge transfer section configured by a MOS transistor including a transfer gate embedded in the surface of the semiconductor substrate, having a bottom portion formed in the vicinity of the photoelectric conversion section and being a gate electrode, and configured to transfer a charge of the photoelectric conversion section to the charge holding section; and
   a notch portion formed in the bottom portion of the transfer gate.
(33) The photodetection apparatus according to (32), in which the notch portion is formed along a side surface of the transfer gate.
(34) A photodetection apparatus including:
   a photoelectric conversion section that is disposed in a semiconductor substrate and performs photoelectric conversion of incident light;
   a charge holding section that is disposed in the vicinity of a surface of the semiconductor substrate and holds a charge generated by the photoelectric conversion;
   a charge transfer section configured by a MOS transistor including a transfer gate embedded in the surface of the semiconductor substrate, having a bottom portion formed in the vicinity of the photoelectric conversion section and being a gate electrode, and configured to transfer a charge of the photoelectric conversion section to the charge holding section; and
   a recess formed on a front surface side of the transfer gate.
(35) The photodetection apparatus according to (34), in which the recess is configured to have a tapered cross section.
(36) The photodetection apparatus according to (35), in which the recess is configured such that the vicinity of an opening portion has a taper angle different from that of the vicinity of a bottom portion.
(37) The photodetection apparatus according to (34), in which a step is formed in the recess.
(38) The photodetection apparatus according to any one of (34) to (36), in which the transfer gate has a tapered cross section.
(39) The photodetection apparatus according to any one of (34) to (38), in which an insulator is disposed in the recess.
(40) The photodetection apparatus according to any one of (34) to (38), in which a void is formed in the recess.

### Reference Signs List

1, 703 PHOTODETECTION APPARATUS
11, 21, 31 SEMICONDUCTOR SUBSTRATE
12, 12a, 12b, 12c, 12d PIXEL
13 PIXEL ARRAY SECTION
22 PIXEL CIRCUIT
101, 101a, 101b, 101c, 101d PHOTOELECTRIC CONVERSION SECTION
102, 102a, 102b, 102c, 102d CHARGE TRANSFER SECTION
103, 103a, 103b, 103c, 103d CHARGE HOLDING SECTION
121, 122, 221 SEMICONDUCTOR REGION
131 SEPARATION SECTION
140, 141, 143 TRANSFER GATE
142 NOTCH PORTION
144 RECESS
145 FILLING PORTION
146 VOID
150 TRANSFER PATH ADJUSTMENT SECTION
265 THROUGH WIRING
305, 306 STEP
11402, 12031, 12101 to 12105 IMAGING SECTION

## Claims

1. A semiconductor apparatus comprising:
a charge transfer section configured by a MOS transistor including a first semiconductor region disposed in a semiconductor substrate, a second semiconductor region disposed in the vicinity of a surface of the semiconductor substrate, and a transfer gate embedded in the vicinity of the surface of the semiconductor substrate, having a bottom portion formed in the vicinity of the first semiconductor region and being a gate electrode, and configured to transfer a charge from one of the first semiconductor region and the second semiconductor region to the other; and
a transfer path adjustment section that is disposed adjacent to the transfer gate, has a bottom portion constituted by an insulator formed in the vicinity of the bottom portion of the transfer gate, and adjusts a transfer path of the charge in the charge transfer section.

2. The semiconductor apparatus according to claim 1, wherein the transfer gate has a shape in which the bottom portion reaches the first semiconductor region.

3. The semiconductor apparatus according to claim 1, wherein the charge transfer section is disposed between a central portion of the first semiconductor region and the second semiconductor region in plan view.

4. The semiconductor apparatus according to claim 1, further comprising a plurality of the transfer path adjustment section.

5. The semiconductor apparatus according to claim 1, further comprising a plurality of pixels including the first semiconductor region, the second semiconductor region, the charge transfer section, and the transfer path adjustment section.

6. The semiconductor apparatus according to claim 5, wherein the second semiconductor region is disposed at an end portion of the pixel.

7. The semiconductor apparatus according to claim 5, further comprising a separation section disposed at a boundary between the pixels.

8. The semiconductor apparatus according to claim 7, wherein the transfer path adjustment section is disposed adjacent to the separation section.

9. The semiconductor apparatus according to claim 7, wherein
the pixel is configured in a shape of a rectangle in plan view, and
the second semiconductor region is disposed at a corner portion of the rectangle.

10. The semiconductor apparatus according to claim 9, wherein the transfer path adjustment section is disposed at another corner portion adjacent to the corner portion.

11. The semiconductor apparatus according to claim 1, further comprising a signal generation section that generates a signal based on the charge held in the second semiconductor region.

12. A semiconductor apparatus comprising:
a charge transfer section configured by a MOS transistor including a first semiconductor region disposed in a semiconductor substrate, a second semiconductor region disposed in the vicinity of a surface of the semiconductor substrate, and a transfer gate embedded in the vicinity of the surface of the semiconductor substrate, having a bottom portion formed in the vicinity of the first semiconductor region and being a gate electrode, and configured to transfer a charge from one of the first semiconductor region and the second semiconductor region to the other; and
a notch portion formed in the bottom portion of the transfer gate.

13. The semiconductor apparatus according to claim 12, wherein the notch portion is formed along a side surface of the transfer gate.

14. A semiconductor apparatus comprising:
a charge transfer section configured by a MOS transistor including a first semiconductor region disposed in a semiconductor substrate, a second semiconductor region disposed in the vicinity of a surface of the semiconductor substrate, and a transfer gate embedded in the vicinity of the surface of the semiconductor substrate, having a bottom portion formed in the vicinity of the first semiconductor region and being a gate electrode, and configured to transfer a charge from one of the first semiconductor region and the second semiconductor region to the other; and
a recess formed on a front surface side of the transfer gate.

15. The semiconductor apparatus according to claim 14, wherein the recess is configured to have a tapered cross section.

16. The semiconductor apparatus according to claim 15, wherein the recess is configured such that the vicinity of an opening portion has a taper angle different from that of the vicinity of a bottom portion.

17. The semiconductor apparatus according to claim 14, wherein a step is formed in the recess.

18. The semiconductor apparatus according to claim 14, wherein the transfer gate has a tapered cross section.

19. The semiconductor apparatus according to claim 14, wherein an insulator is disposed in the recess.

20. The semiconductor apparatus according to claim 14, wherein a void is formed in the recess.
